(19)

Europäisches
Patentamt
European
Patent Office
Office européen
des brevets

(11) **EP 3 703 467 A1**

(12) **EUROPEAN PATENT APPLICATION**

(43) Date of publication:
**02.09.2020 Bulletin 2020/36**

(51) Int Cl.:
**H05B 1/02** *(2006.01)*    **H05B 3/26** *(2006.01)*
**H05B 3/82** *(2006.01)*

(21) Application number: **20159704.4**

(22) Date of filing: **27.02.2020**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **28.02.2019 JP 2019035937**

(71) Applicant: **CANON KABUSHIKI KAISHA
OHTA-KU
Tokyo 146-8501 (JP)**

(72) Inventors:
• **IMANAKA, Yoshiyuki**
  **Ohta-ku,, Tokyo 146-8501 (JP)**

• **KUBOTA, Masahiko**
  **Ohta-ku,, Tokyo 146-8501 (JP)**
• **YAMADA, Akitoshi**
  **Ohta-ku,, Tokyo 146-8501 (JP)**
• **YANAI, Yumi**
  **Ohta-ku,, Tokyo 146-8501 (JP)**
• **ARIMIZU, Hiroshi**
  **Ohta-ku,, Tokyo 146-8501 (JP)**
• **ISHINAGA, Hiroyuki**
  **Ohta-ku,, Tokyo 146-8501 (JP)**
• **OZAKI, Teruo**
  **Ohta-ku,, Tokyo 146-8501 (JP)**

(74) Representative: **TBK
Bavariaring 4-6
80336 München (DE)**

(54) **ULTRAFINE BUBBLE GENERATING APPARATUS**

(57)    An ultrafine bubble generating apparatus (300) that generates ultrafine bubbles (11) by causing a heating element (10) to generate film boiling (13) in a liquid (W) includes: an element substrate (12) including a heating part (1250) provided with multiple heating elements, in which the element substrate is configured to suppress variation of energies inputted to the heating elements in the heating part.

FIG.14A

**EP 3 703 467 A1**

**Description**

BACKGROUND OF THE INVENTION

Field of the Invention

The present invention relates to an ultrafine bubble generating apparatus for generating ultrafine bubbles smaller than 1.0 $\mu$m in diameter.

Description of the Related Art

Recently, there have been developed techniques for applying the features of fine bubbles such as microbubbles in micrometer-size in diameter and nanobubbles in nanometer-size in diameter. Especially, the utility of ultrafine bubbles (hereinafter also referred to as "UFBs") smaller than 1.0 $\mu$m in diameter have been confirmed in various fields.
Japanese Patent No. 6118544 discloses a fine air bubble generating apparatus that generates fine bubbles by ejecting from a depressurizing nozzle a pressurized liquid in which a gas is pressurized and dissolved. Japanese Patent No. 4456176 discloses an apparatus that generates fine bubbles by repeating separating and converging of flows of a gas-mixed liquid with a mixing unit.

SUMMARY OF THE INVENTION

The present invention in its first aspect provides an ultrafine bubble generating apparatus as specified in claims 1 to 22.
Further features of the present invention will become apparent from the following description of exemplary embodiments with reference to the attached drawings.

BRIEF DESCRIPTION OF THE DRAWINGS

Fig. 1 is a diagram illustrating an example of a UFB generating apparatus;
Fig. 2 is a schematic configuration diagram of a pre-processing unit;
Figs. 3A and 3B are a schematic configuration diagram of a dissolving unit and a diagram for describing the dissolving states in a liquid;
Fig. 4 is a schematic configuration diagram of a T-UFB generating unit;
Figs. 5A and 5B are diagrams for describing details of a heating element;
Figs. 6A and 6B are diagrams for describing the states of film boiling on the heating element;
Figs. 7A to 7D are diagrams illustrating the states of generation of UFBs caused by expansion of a film boiling bubble;
Figs. 8A to 8C are diagrams illustrating the states of generation of UFBs caused by shrinkage of the film boiling bubble;
Figs. 9A to 9C are diagrams illustrating the states of generation of UFBs caused by reheating of the liquid;
Figs. 10A and 10B are diagrams illustrating the states of generation of UFBs caused by shock waves made by disappearance of the bubble generated by the film boiling;
Figs. 11A to 11C are diagrams illustrating configuration examples of a post-processing unit;
Figs. 12A and 12B are diagrams describing layouts of an element substrate;
Figs. 13A and 13B are diagrams illustrating electrical equivalent circuits;
Figs. 14A to 14C are diagrams describing an example of reducing a difference between wiring resistance losses;
Figs. 15A to 15F are diagrams describing a layout and the like of the element substrate;
Figs. 16A to 16E are diagrams describing examples of stably generating UFBs;
Figs. 17A to 17G are diagrams describing examples of stably generating UFBs;
Figs. 18A to 18C are diagrams describing examples of stably generating UFBs;
Figs. 19A to 19C are diagrams describing examples of stably generating UFBs;
Figs. 20A to 20C are diagrams describing examples of stably generating UFBs;
Figs. 21A to 21D are diagrams describing examples of stably generating UFBs;
Figs. 22A to 22D are diagrams describing examples of stably generating UFBs;
Figs. 23A to 23D are diagrams describing examples of stably generating UFBs; and
Figs. 24A to 24D are diagrams describing an example of stably generating UFBs.

DESCRIPTION OF THE EMBODIMENTS

Both the apparatuses described in Japanese Patent Nos. 6118544 and 4456176 generate not only the UFBs of nanometer-size in diameter but also relatively a large number of milli-bubbles of millimeter-size in diameter and microbubbles of micrometer-size in diameter. However, because the milli-bubbles and the microbubbles are affected by the buoyancy, the bubbles are likely to gradually rise to the liquid surface and disappear during long-time storage.

On the other hand, the UFBs of nanometer-size in diameter are suitable for long-time storage since they are less likely to be affected by the buoyancy and float in the liquid with Brownian motion. However, when the UFBs are generated with the milli-bubbles and the microbubbles or the gas-liquid interface energy of the UFBs is small, the UFBs are affected by the disappearance of the milli-bubbles and the microbubbles and decreased over time. That is, in order to obtain a UFB-containing liquid in which the concentration reduction of the UFBs can be suppressed even during long-time storage, it is required to generate highly pure and highly concentrated UFBs with large gas-liquid interface energy when generating a UFB-containing liquid.

<<Configuration of UFB Generating Apparatus>>

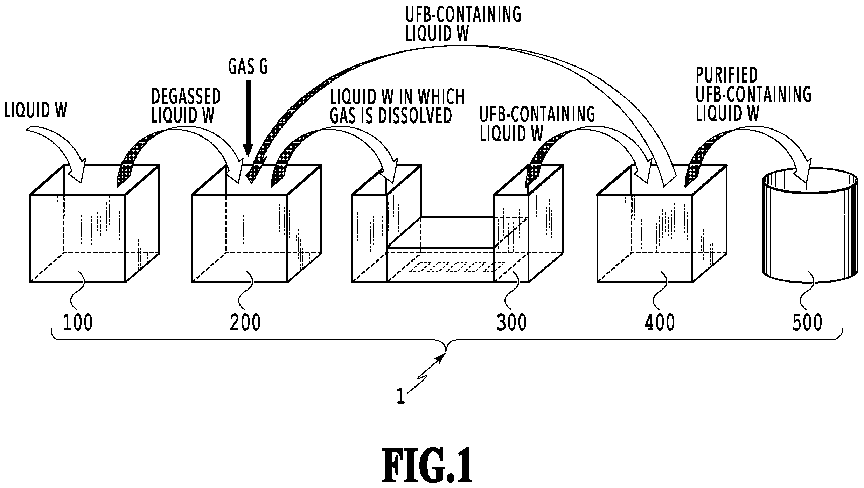

Fig. 1 is a diagram illustrating an example of an ultrafine bubble generating apparatus (UFB generating apparatus) applicable to the present invention. A UFB generating apparatus 1 of this embodiment includes a pre-processing unit 100, dissolving unit 200, a T-UFB generating unit 300, a post-processing unit 400, and a collecting unit 500. Each unit performs unique processing on a liquid W such as tap water supplied to the pre-processing unit 100 in the above order, and the thus-processed liquid W is collected as a T-UFB-containing liquid by the collecting unit 500. Functions and configurations of the units are described below. Although details are described later, UFBs generated by utilizing the film boiling caused by rapid heating are referred to as thermal-ultrafine bubbles (T-UFBs) in this specification.

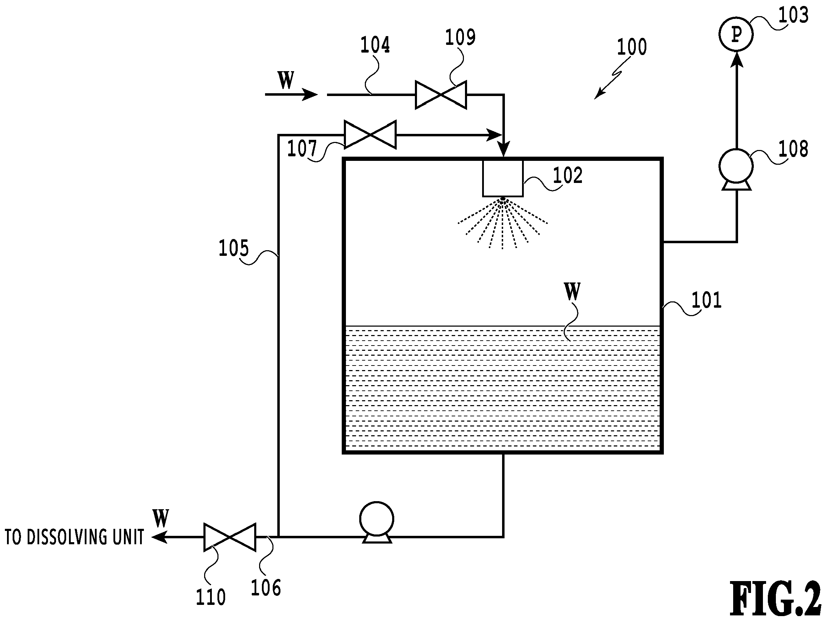

Fig. 2 is a schematic configuration diagram of the pre-processing unit 100. The pre-processing unit 100 of this embodiment performs a degassing treatment on the supplied liquid W. The pre-processing unit 100 mainly includes a degassing container 101, a shower head 102, a depressurizing pump 103, a liquid introduction passage 104, a liquid circulation passage 105, and a liquid discharge passage 106. For example, the liquid W such as tap water is supplied to the degassing container 101 from the liquid introduction passage 104 through a valve 109. In this process, the shower head 102 provided in the degassing container 101 sprays a mist of the liquid W in the degassing container 101. The shower head 102 is for prompting the gasification of the liquid W; however, a centrifugal and the like may be used instead as the mechanism for producing the gasification prompt effect.

When a certain amount of the liquid W is reserved in the degassing container 101 and then the depressurizing pump 103 is activated with all the valves closed, already-gasified gas components are discharged, and gasification and discharge of gas components dissolved in the liquid W are also prompted. In this process, the internal pressure of the degassing container 101 may be depressurized to around several hundreds to thousands of Pa (1.0 Torr to 10.0 Torr) while checking a manometer 108. The gases to be removed by the pre-processing unit 100 includes nitrogen, oxygen, argon, carbon dioxide, and so on, for example.

The above-described degassing processing can be repeatedly performed on the same liquid W by utilizing the liquid circulation passage 105. Specifically, the shower head 102 is operated with the valve 109 of the liquid introduction passage 104 and a valve 110 of the liquid discharge passage 106 closed and a valve 107 of the liquid circulation passage 105 opened. This allows the liquid W reserved in the degassing container 101 and degassed once to be resprayed in the degassing container 101 from the shower head 102. In addition, with the depressurizing pump 103 operated, the gasification processing by the shower head 102 and the degassing processing by the depressurizing pump 103 are repeatedly performed on the same liquid W. Every time the above processing utilizing the liquid circulation passage 105 is performed repeatedly, it is possible to decrease the gas components contained in the liquid W in stages. Once the liquid W degassed to a desired purity is obtained, the liquid W is transferred to the dissolving unit 200 through the liquid discharge passage 106 with the valve 110 opened.

Fig. 2 illustrates the pre-processing 100 that depressurizes the gas part to gasify the solute; however, the method of degassing the solution is not limited thereto. For example, a heating and boiling method for boiling the liquid W to gasify the solute may be employed, or a film degassing method for increasing the interface between the liquid and the gas using hollow fibers. A SEPAREL series (produced by DIC corporation) is commercially supplied as the degassing module using the hollow fibers. The SEPAREL series uses poly(4-methylpentene-1) (PMP) for the raw material of the hollow fibers and is used for removing air bubbles from ink and the like mainly supplied for a piezo head. In addition, two or more of an evacuating method, the heating and boiling method, and the film degassing method may be used together.

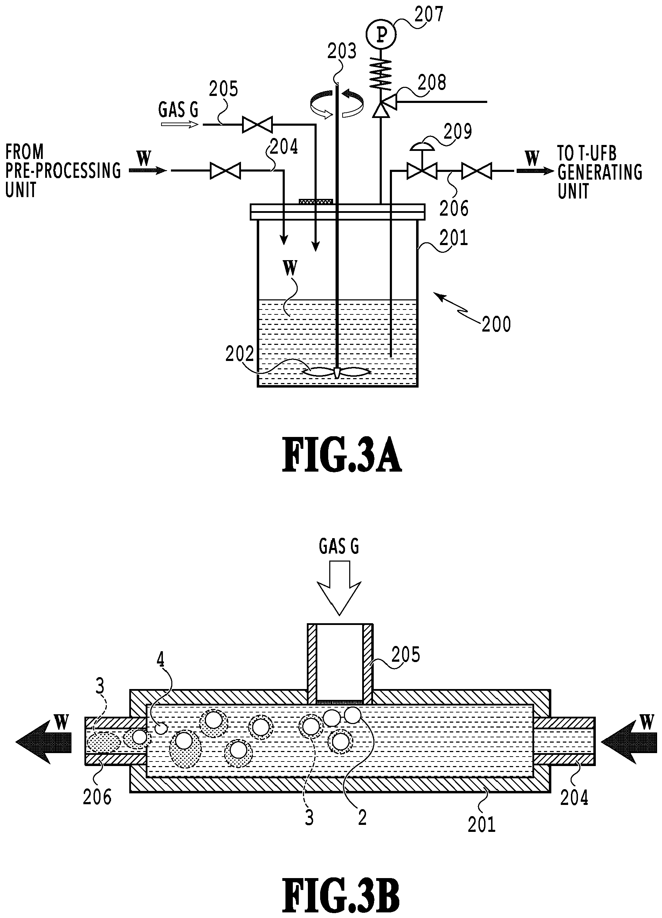

Figs. 3A and 3B are a schematic configuration diagram of the dissolving unit 200 and a diagram for describing the dissolving states in the liquid. The dissolving unit 200 is a unit for dissolving a desired gas into the liquid W supplied from the pre-processing unit 100. The dissolving unit 200 of this embodiment mainly includes a dissolving container 201, a rotation shaft 203 provided with a rotation plate 202, a liquid introduction passage 204, a gas introduction passage 205, a liquid discharge passage 206, and a pressurizing pump 207.

The liquid W supplied from the pre-processing unit 100 is supplied and reserved into the dissolving container 201 through the liquid introduction passage 204. Meanwhile, a gas G is supplied to the dissolving container 201 through the gas introduction passage 205.

Once predetermined amounts of the liquid W and the gas G are reserved in the dissolving container 201, the pressurizing pump 207 is activated to increase the internal pressure of the dissolving container 201 to about 0.5 MPa. A safety valve 208 is arranged between the pressurizing pump 207 and the dissolving container 201. With the rotation plate 202 in the liquid rotated via the rotation shaft 203, the gas G supplied to the dissolving container 201 is transformed into air bubbles, and the contact area between the gas G and the liquid W is increased to prompt the dissolution into the liquid W. This operation is continued until the solubility of the gas G reaches almost the maximum saturation solubility. In this case, a unit for decreasing the temperature of the liquid may be provided to dissolve the gas as much as possible. When the gas is with low solubility, it is also possible to increase the internal pressure of the dissolving container 201 to 0.5 MPa or higher. In this case, the material and the like of the container need to be the optimum for safety sake.

Once the liquid W in which the components of the gas G are dissolved at a desired concentration is obtained, the liquid W is discharged through the liquid discharge passage 206 and supplied to the T-UFB generating unit 300. In this process, a back-pressure valve 209 adjusts the flow pressure of the liquid W to prevent excessive increase of the pressure during the supplying.

Fig. 3B is a diagram schematically illustrating the dissolving states of the gas G put in the dissolving container 201. An air bubble 2 containing the components of the gas G put in the liquid W is dissolved from a portion in contact with the liquid W. The air bubble 2 thus shrinks gradually, and a gas-dissolved liquid 3 then appears around the air bubble 2. Since the air bubble 2 is affected by the buoyancy, the air bubble 2 may be moved to a position away from the center of the gas-dissolved liquid 3 or be separated out from the gas-dissolved liquid 3 to become a residual air bubble 4. Specifically, in the liquid W to be supplied to the T-UFB generating unit 300 through the liquid discharge passage 206, there is a mix of the air bubbles 2 surrounded by the gas-dissolved liquids 3 and the air bubbles 2 and the gas-dissolved liquids 3 separated from each other.

The gas-dissolved liquid 3 in the drawings means "a region of the liquid W in which the dissolution concentration of the gas G mixed therein is relatively high." In the gas components actually dissolved in the liquid W, the concentration of the gas components in the gas-dissolved liquid 3 is the highest at a portion surrounding the air bubble 2. In a case where the gas-dissolved liquid 3 is separated from the air bubble 2 the concentration of the gas components of the gas-dissolved liquid 3 is the highest at the center of the region, and the concentration is continuously decreased as away from the center. That is, although the region of the gas-dissolved liquid 3 is surrounded by a broken line in Fig. 3 for the sake of explanation, such a clear boundary does not actually exist. In addition, in the present discloser, a gas that cannot be dissolved completely may be accepted to exist in the form of an air bubble in the liquid.

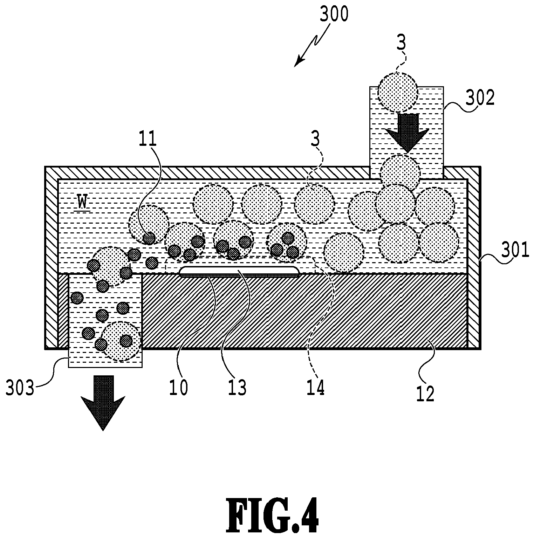

Fig. 4 is a schematic configuration diagram of the T-UFB generating unit 300. The T-UFB generating unit 300 mainly includes a chamber 301, a liquid introduction passage 302, and a liquid discharge passage 303. The flow from the liquid introduction passage 302 to the liquid discharge passage 303 through the chamber 301 is formed by a not-illustrated flow pump. Various pumps including a diaphragm pump, a gear pump, and a screw pump may be employed as the flow pump. In in the liquid W introduced from the liquid introduction passage 302, the gas-dissolved liquid 3 of the gas G put by the dissolving unit 200 is mixed.

An element substrate 12 provided with a heating element 10 is arranged on a bottom section of the chamber 301. With a predetermined voltage pulse applied to the heating element 10, a bubble 13 generated by the film boiling (hereinafter, also referred to as a film boiling bubble 13) is generated in a region in contact with the heating element 10. Then, an ultrafine bubble (UFB) 11 containing the gas G is generated caused by expansion and shrinkage of the film boiling bubble 13. As a result, a UFB-containing liquid W containing many UFBs 11 is discharged from the liquid discharge passage 303.

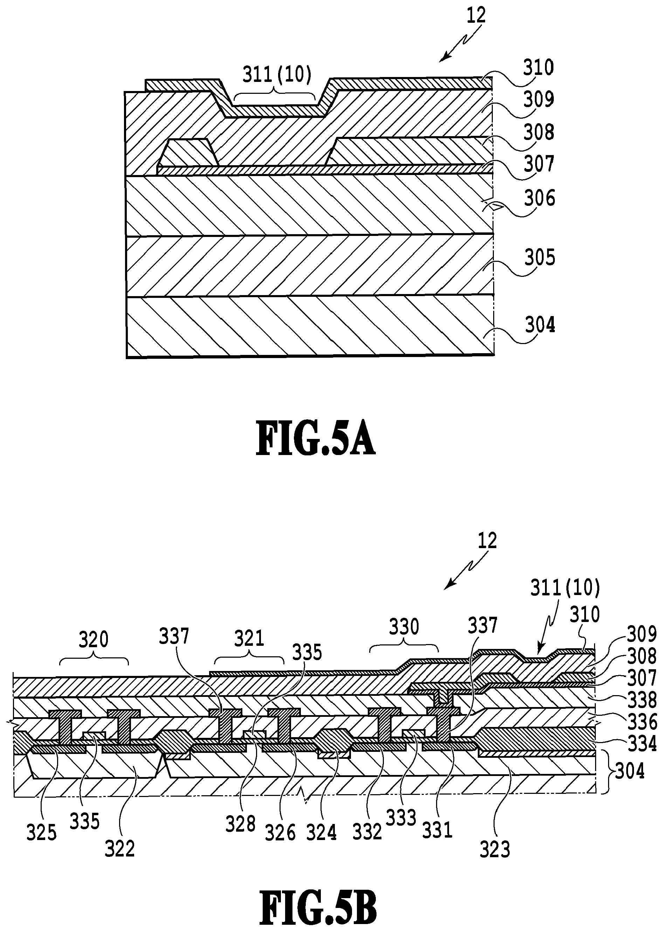

Figs. 5A and 5B are diagrams for illustrating a detailed configuration of the heating element 10. Fig. 5A illustrates a closeup view of the heating element 10, and Fig. 5B illustrates a cross-sectional view of a wider region of the element substrate 12 including the heating element 10.

As illustrated in Fig. 5A, in the element substrate 12 of this embodiment, a thermal oxide film 305 as a heat-accumulating layer and an interlaminar film 306 also served as a heat-accumulating layer are laminated on a surface of a silicon substrate 304. An $SiO_2$ film or an SiN film may be used as the interlaminar film 306. A resistive layer 307 is formed on a surface of the interlaminar film 306, and a wiring 308 is partially formed on a surface of the resistive layer 307. An Al-alloy wiring of Al, Al-Si, Al-Cu, or the like may be used as the wiring 308. A protective layer 309 made of an $SiO_2$ film or an $Si_3N_4$ film is formed on surfaces of the wiring 308, the resistive layer 307, and the interlaminar film 306.

A cavitation-resistant film 310 for protecting the protective layer 309 from chemical and physical impacts due to the heat evolved by the resistive layer 307 is formed on a portion and around the portion on the surface of the protective layer 309, the portion corresponding to a heat-acting portion 311 that eventually becomes the heating element 10. A region on the surface of the resistive layer 307 in which the wiring 308 is not formed is the heat-acting portion 311 in which the resistive layer 307 evolves heat. The heating portion of the resistive layer 307 on which the wiring 308 is not formed functions as the heating element (heater) 10. As described above, the layers in the element substrate 12 are sequentially formed on the surface of the silicon substrate 304 by a semiconductor production technique, and the heat-acting portion 311 is thus provided on the silicon substrate 304.

The configuration illustrated in the drawings is an example, and various other configurations are applicable. For example, a configuration in which the laminating order of the resistive layer 307 and the wiring 308 is opposite, and a configuration in which an electrode is connected to a lower surface of the resistive layer 307 (so-called a plug electrode configuration) are applicable. In other words, as described later, any configuration may be applied as long as the configuration allows the heat-acting portion 311 to heat the liquid for generating the film boiling in the liquid.

Fig. 5B is an example of a cross-sectional view of a region including a circuit connected to the wiring 308 in the element substrate 12. An N-type well region 322 and a P-type well region 323 are partially provided in a top layer of the silicon substrate 304, which is a P-type conductor. AP-MOS 320 is formed in the N-type well region 322 and an N-MOS 321 is formed in the P-type well region 323 by introduction and diffusion of impurities by the ion implantation and the like in the general MOS process.

The P-MOS 320 includes a source region 325 and a drain region 326 formed by partial introduction of N-type or P-type impurities in a top layer of the N-type well region 322, a gate wiring 335, and so on. The gate wiring 335 is deposited on a part of a top surface of the N-type well region 322 excluding the source region 325 and the drain region 326, with a gate insulation film 328 of several hundreds of Å in thickness interposed between the gate wiring 335 and the top surface of the N-type well region 322.

The N-MOS 321 includes the source region 325 and the drain region 326 formed by partial introduction of N-type or P-type impurities in a top layer of the P-type well region 323, the gate wiring 335, and so on. The gate wiring 335 is deposited on a part of a top surface of the P-type well region 323 excluding the source region 325 and the drain region 326, with the gate insulation film 328 of several hundreds of Å in thickness interposed between the gate wiring 335 and the top surface of the P-type well region 323. The gate wiring 335 is made of polysilicon of 3000 Å to 5000 Å in thickness deposited by the CVD method. A C-MOS logic is constructed with the P-MOS 320 and the N-MOS 321.

In the P-type well region 323, an N-MOS transistor 330 for driving an electrothermal conversion element (heating resistance element) is formed on a portion different from the portion including the N-MOS 321. The N-MOS transistor 330 includes a source region 332 and a drain region 331 partially provided in the top layer of the P-type well region 323 by the steps of introduction and diffusion of impurities, a gate wiring 333, and so on. The gate wiring 333 is deposited on a part of the top surface of the P-type well region 323 excluding the source region 332 and the drain region 331, with the gate insulation film 328 interposed between the gate wiring 333 and the top surface of the P-type well region 323.

In this example, the N-MOS transistor 330 is used as the transistor for driving the electrothermal conversion element. However, the transistor for driving is not limited to the N-MOS transistor 330, and any transistor may be used as long as the transistor has a capability of driving multiple electrothermal conversion elements individually and can implement the above-described fine configuration. Although the electrothermal conversion element and the transistor for driving the electrothermal conversion element are formed on the same substrate in this example, those may be formed on different substrates separately.

An oxide film separation region 324 is formed by field oxidation of 5000 Å to 10000 Å in thickness between the elements, such as between the P-MOS 320 and the N-MOS 321 and between the N-MOS 321 and the N-MOS transistor 330. The oxide film separation region 324 separates the elements. A portion of the oxide film separation region 324 corresponding to the heat-acting portion 311 functions as a heat-accumulating layer 334, which is the first layer on the silicon substrate 304.

An interlayer insulation film 336 including a PSG film, a BPSG film, or the like of about 7000 Å in thickness is formed by the CVD method on each surface of the elements such as the P-MOS 320, the N-MOS 321, and the N-MOS transistor 330. After the interlayer insulation film 336 is made flat by heat treatment, an Al electrode 337 as a first wiring layer is formed in a contact hole penetrating through the interlayer insulation film 336 and the gate insulation film 328. On surfaces of the interlayer insulation film 336 and the Al electrode 337, an interlayer insulation film 338 including an $SiO_2$ film of 10000 Å to 15000 Å in thickness is formed by a plasma CVD method. On the surface of the interlayer insulation film 338, a resistive layer 307 including a TaSiN film of about 500 Å in thickness is formed by a co-sputter method on portions corresponding to the heat-acting portion 311 and the N-MOS transistor 330. The resistive layer 307 is electrically connected with the Al electrode 337 near the drain region 331 via a through-hole formed in the interlayer insulation film 338. On the surface of the resistive layer 307, the wiring 308 of Al as a second wiring layer for a wiring to each electrothermal conversion element is formed. The protective layer 309 on the surfaces of the wiring 308, the resistive layer 307, and the interlayer insulation film 338 includes an SiN film of 3000 Å in thickness formed by the plasma CVD method. The cavitation-resistant film 310 deposited on the surface of the protective layer 309 includes a thin film of about 2000 Å in thickness, which is at least one metal selected from the group consisting of Ta, Fe, Ni, Cr, Ge, Ru, Zr, Ir, and the like. Various materials other than the above-described TaSiN such as TaN, CrSiN, TaAl, WSiN, and the like can be applied as long as the material can generate the film boiling in the liquid.

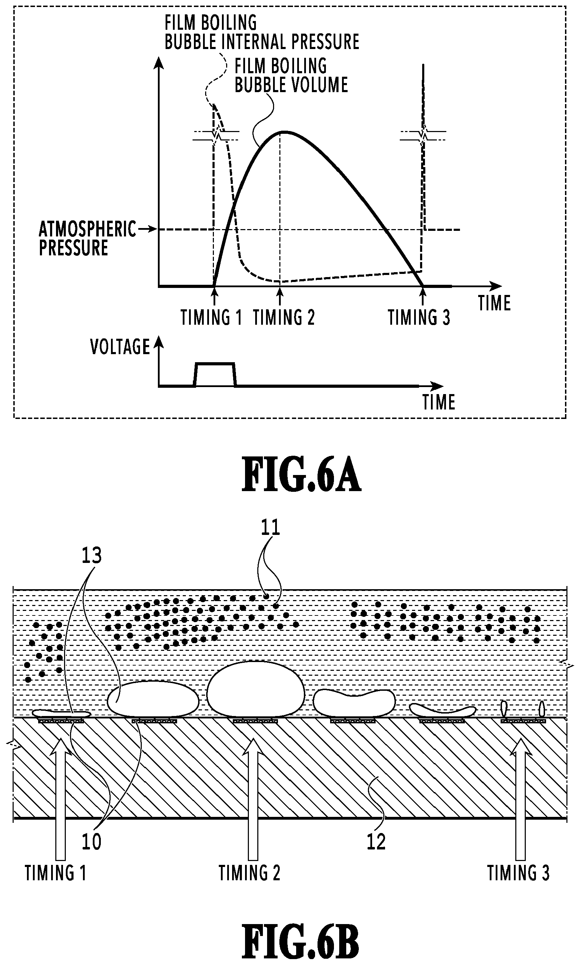

Figs. 6A and 6B are diagrams illustrating the states of the film boiling when a predetermined voltage pulse is applied to the heating element 10. In this case, the case of generating the film boiling under atmospheric pressure is described. In Fig. 6A, the horizontal axis represents time. The vertical axis in the lower graph represents a voltage applied to the heating element 10, and the vertical axis in the upper graph represents the volume and the internal pressure of the film boiling bubble 13 generated by the film boiling. On the other hand, Fig. 6B illustrates the states of the film boiling bubble 13 in association with timings 1 to 3 shown in Fig. 6A. Each of the states is described below in chronological order. The UFBs 11 generated by the film boiling as described later are mainly generated near a surface of the film boiling bubble 13. The states illustrated in Fig. 6B are the states where the UFBs 11 generated by the generating unit 300 are resupplied to the dissolving unit 200 through the circulation route, and the liquid containing the UFBs 11 is resupplied to the liquid passage of the generating unit 300, as illustrated in Fig. 1.

Before a voltage is applied to the heating element 10, the atmospheric pressure is substantially maintained in the chamber 301. Once a voltage is applied to the heating element 10, the film boiling is generated in the liquid in contact with the heating element 10, and a thus-generated air bubble (hereinafter, referred to as the film boiling bubble 13) is expanded by a high pressure acting from inside (timing 1). A bubbling pressure in this process is expected to be around 8 to 10 MPa, which is a value close to a saturation vapor pressure of water.

The time for applying a voltage (pulse width) is around 0.5 $\mu$sec to 10.0 $\mu$sec, and the film boiling bubble 13 is expanded by the inertia of the pressure obtained in timing 1 even after the voltage application. However, a negative pressure generated with the expansion is gradually increased inside the film boiling bubble 13, and the negative pressure acts in a direction to shrink the film boiling bubble 13. After a while, the volume of the film boiling bubble 13 becomes the maximum in timing 2 when the inertial force and the negative pressure are balanced, and thereafter the film boiling bubble 13 shrinks rapidly by the negative pressure.

In the disappearance of the film boiling bubble 13, the film boiling bubble 13 disappears not in the entire surface of the heating element 10 but in one or more extremely small regions. For this reason, on the heating element 10, further greater force than that in the bubbling in timing 1 is generated in the extremely small region in which the film boiling bubble 13 disappears (timing 3).

The generation, expansion, shrinkage, and disappearance of the film boiling bubble 13 as described above are repeated every time a voltage pulse is applied to the heating element 10, and new UFBs 11 are generated each time.

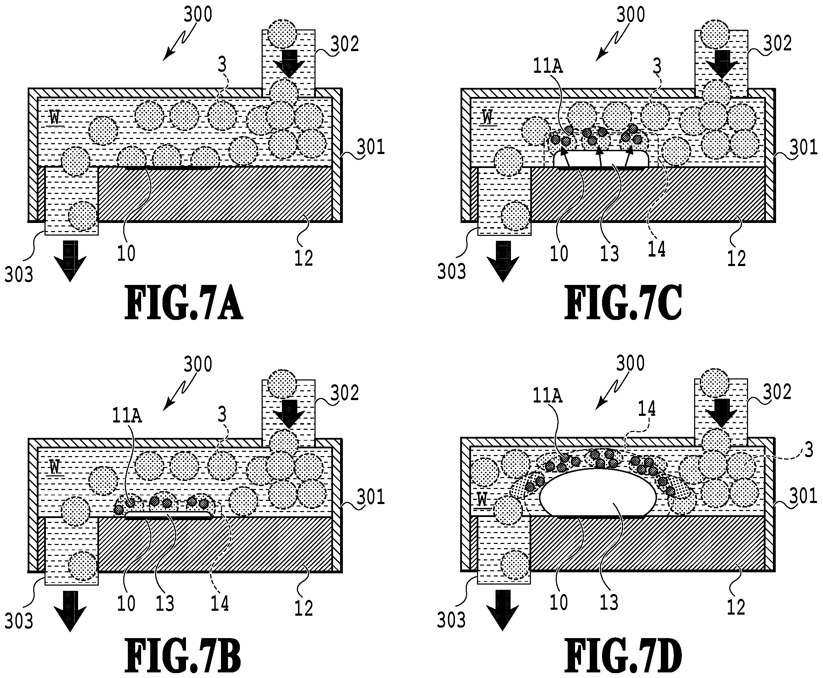

The states of generation of the UFBs 11 in each process of the generation, expansion, shrinkage, and disappearance of the film boiling bubble 13 are further described in detail with reference to Figs. 7A to 10B.

Figs. 7A to 7D are diagrams schematically illustrating the states of generation of the UFBs 11 caused by the generation and the expansion of the film boiling bubble 13. Fig. 7A illustrates the state before the application of a voltage pulse to the heating element 10. The liquid W in which the gas-dissolved liquids 3 are mixed flows inside the chamber 301.

Fig. 7B illustrates the state where a voltage is applied to the heating element 10, and the film boiling bubble 13 is evenly generated in almost all over the region of the heating element 10 in contact with the liquid W. When a voltage is applied, the surface temperature of the heating element 10 rapidly increases at a speed of 10°C/$\mu$sec. The film boiling occurs at a time point when the temperature reaches almost 300°C, and the film boiling bubble 13 is thus generated.

Thereafter, the surface temperature of the heating element 10 keeps increasing to around 600 to 800°C during the pulse application, and the liquid around the film boiling bubble 13 is rapidly heated as well. In Fig. 7B, a region of the liquid that is around the film boiling bubble 13 and to be rapidly heated is indicated as a not-yet-bubbling high temperature region 14. The gas-dissolved liquid 3 within the not-yet-bubbling high temperature region 14 exceeds the thermal dissolution limit and is vaporized to become the UFB. The thus-vaporized air bubbles have diameters of around 10 nm to 100 nm and large gas-liquid interface energy. Thus, the air bubbles float independently in the liquid W without disappearing in a short time. In this embodiment, the air bubbles generated by the thermal action from the generation to the expansion of the film boiling bubble 13 are called first UFBs 11A.

Fig. 7C illustrates the state where the film boiling bubble 13 is expanded. Even after the voltage pulse application to the heating element 10, the film boiling bubble 13 continues expansion by the inertia of the force obtained from the generation thereof, and the not-yet-bubbling high temperature region 14 is also moved and spread by the inertia. Specifically, in the process of the expansion of the film boiling bubble 13, the gas-dissolved liquid 3 within the not-yet-bubbling high temperature region 14 is vaporized as a new air bubble and becomes the first UFB 11A.

Fig. 7D illustrates the state where the film boiling bubble 13 has the maximum volume. As the film boiling bubble 13 is expanded by the inertia, the negative pressure inside the film boiling bubble 13 is gradually increased along with the expansion, and the negative pressure acts to shrink the film boiling bubble 13. At a time point when the negative pressure and the inertial force are balanced, the volume of the film boiling bubble 13 becomes the maximum, and then the shrinkage is started.

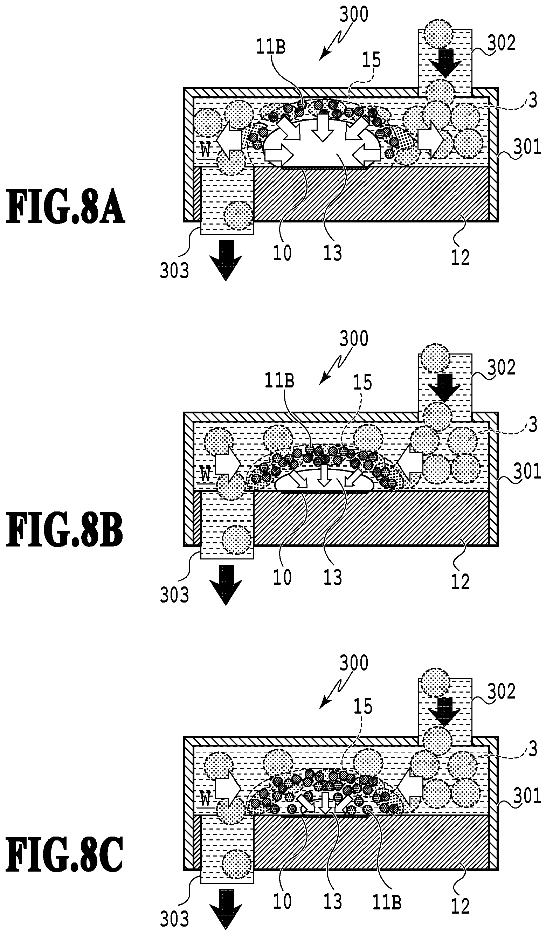

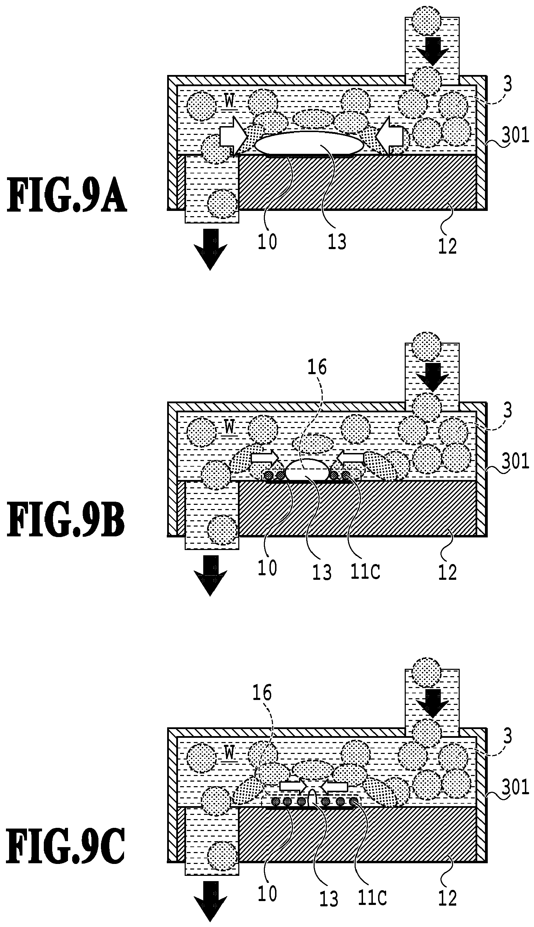

In the shrinking stage of the film boiling bubble 13, there are UFBs generated by the processes illustrated in Figs. 8A to 8C (second UFBs 11B) and UFBs generated by the processes illustrated in Figs. 9A to 9C (third UFBs 11C). It is considered that these two processes are made simultaneously.

Figs. 8A to 8C are diagrams illustrating the states of generation of the UFBs 11 caused by the shrinkage of the film boiling bubble 13. Fig. 8A illustrates the state where the film boiling bubble 13 starts shrinking. Although the film boiling bubble 13 starts shrinking, the surrounding liquid W still has the inertial force in the expansion direction. Because of this, the inertial force acting in the direction of going away from the heating element 10 and the force going toward the heating element 10 caused by the shrinkage of the film boiling bubble 13 act in a surrounding region extremely close to the film boiling bubble 13, and the region is depressurized. The region is indicated in the drawings as a not-yet-bubbling negative pressure region 15.

The gas-dissolved liquid 3 within the not-yet-bubbling negative pressure region 15 exceeds the pressure dissolution limit and is vaporized to become an air bubble. The thus-vaporized air bubbles have diameters of about 100 nm and thereafter float independently in the liquid W without disappearing in a short time. In this embodiment, the air bubbles vaporized by the pressure action during the shrinkage of the film boiling bubble 13 are called the second UFBs 11B.

Fig. 8B illustrates a process of the shrinkage of the film boiling bubble 13. The shrinking speed of the film boiling bubble 13 is accelerated by the negative pressure, and the not-yet-bubbling negative pressure region 15 is also moved along with the shrinkage of the film boiling bubble 13. Specifically, in the process of the shrinkage of the film boiling bubble 13, the gas-dissolved liquids 3 within a part over the not-yet-bubbling negative pressure region 15 are precipitated one after another and become the second UFBs 11B.

Fig. 8C illustrates the state immediately before the disappearance of the film boiling bubble 13. Although the moving speed of the surrounding liquid W is also increased by the accelerated shrinkage of the film boiling bubble 13, a pressure loss occurs due to a flow passage resistance in the chamber 301. As a result, the region occupied by the not-yet-bubbling negative pressure region 15 is further increased, and a number of the second UFBs 11B are generated.

Figs. 9A to 9C are diagrams illustrating the states of generation of the UFBs by reheating of the liquid W during the shrinkage of the film boiling bubble 13. Fig. 9A illustrates the state where the surface of the heating element 10 is covered with the shrinking film boiling bubble 13.

Fig. 9B illustrates the state where the shrinkage of the film boiling bubble 13 has progressed, and a part of the surface of the heating element 10 comes in contact with the liquid W. In this state, there is heat left on the surface of the heating element 10, but the heat is not high enough to cause the film boiling even if the liquid W comes in contact with the surface. A region of the liquid to be heated by coming in contact with the surface of the heating element 10 is indicated in the drawings as a not-yet-bubbling reheated region 16. Although the film boiling is not made, the gas-dissolved liquid 3 within the not-yet-bubbling reheated region 16 exceeds the thermal dissolution limit and is vaporized. In this embodiment, the air bubbles generated by the reheating of the liquid W during the shrinkage of the film boiling bubble 13 are called the third UFBs 11C.

Fig. 9C illustrates the state where the shrinkage of the film boiling bubble 13 has further progressed. The smaller the film boiling bubble 13, the greater the region of the heating element 10 in contact with the liquid W, and the third UFBs 11C are generated until the film boiling bubble 13 disappears.

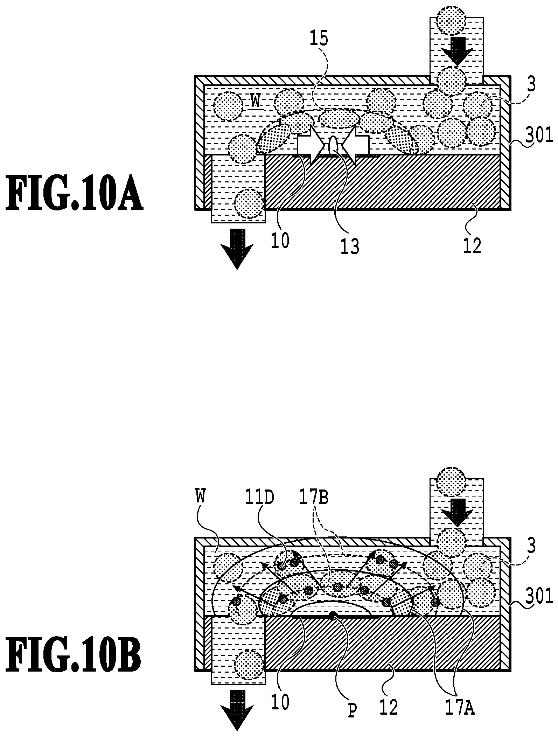

Figs. 10A and 10B are diagrams illustrating the states of generation of the UFBs caused by an impact from the disappearance of the film boiling bubble 13 generated by the film boiling (that is, a type of cavitation). Fig. 10A illustrates the state immediately before the disappearance of the film boiling bubble 13. In this state, the film boiling bubble 13 shrinks rapidly by the internal negative pressure, and the not-yet-bubbling negative pressure region 15 surrounds the film boiling bubble 13.

Fig. 10B illustrates the state immediately after the film boiling bubble 13 disappears at a point P. When the film boiling bubble 13 disappears, acoustic waves ripple concentrically from the point P as a starting point due to the impact of the disappearance. The acoustic wave is a collective term of an elastic wave that is propagated through anything regardless of gas, liquid, and solid. In this embodiment, compression waves of the liquid W, which are a high pressure surface 17A and a low pressure surface 17B of the liquid W, are propagated alternately.

In this case, the gas-dissolved liquid 3 within the not-yet-bubbling negative pressure region 15 is resonated by the shock waves made by the disappearance of the film boiling bubble 13, and the gas-dissolved liquid 3 exceeds the pressure dissolution limit and the phase transition is made in timing when the low pressure surface 17B passes therethrough. Specifically, a number of air bubbles are vaporized in the not-yet-bubbling negative pressure region 15 simultaneously with the disappearance of the film boiling bubble 13. In this embodiment, the air bubbles generated by the shock waves made by the disappearance of the film boiling bubble 13 are called fourth UFBs 11D.

The fourth UFBs 11D generated by the shock waves made by the disappearance of the film boiling bubble 13 suddenly appear in an extremely short time (1 $\mu$S or less) in an extremely narrow thin film-shaped region. The diameter is sufficiently smaller than that of the first to third UFBs, and the gas-liquid interface energy is higher than that of the first to third UFBs. For this reason, it is considered that the fourth UFBs 11D have different characteristics from the first to third UFBs 11A to 11C and generate different effects.

Additionally, the fourth UFBs 11D are evenly generated in many parts of the region of the concentric sphere in which the shock waves are propagated, and the fourth UFBs 11D evenly exist in the chamber 301 from the generation thereof. Although many first to third UFBs already exist in the timing of the generation of the fourth UFBs 11D, the presence of the first to third UFBs does not affect the generation of the fourth UFBs 11D greatly. It is also considered that the first to third UFBs do not disappear due to the generation of the fourth UFBs 11D.

As described above, it is expected that the UFBs 11 are generated in the multiple stages from the generation to the disappearance of the film boiling bubble 13 by the heat generation of the heating element 10. The first UFBs 11A, the second UFBs 11B, and the third UFBs 11C are generated near the surface of the film boiling bubble generated by the film boiling. In this case, near means a region within about 20 μm from the surface of the film boiling bubble. The fourth UFBs 11D are generated in a region through which the shock waves are propagated when the air bubble disappears. Although the above example illustrates the stages to the disappearance of the film boiling bubble 13, the way of generating the UFBs is not limited thereto. For example, with the generated film boiling bubble 13 communicating with the atmospheric air before the bubble disappearance, the UFBs can be generated also if the film boiling bubble 13 does not reach the disappearance.

Next, remaining properties of the UFBs are described. The higher the temperature of the liquid, the lower the dissolution properties of the gas components, and the lower the temperature, the higher the dissolution properties of the gas components. In other words, the phase transition of the dissolved gas components is prompted and the generation of the UFBs becomes easier as the temperature of the liquid is higher. The temperature of the liquid and the solubility of the gas are in the inverse relationship, and the gas exceeding the saturation solubility is transformed into air bubbles and appeared in the liquid as the liquid temperature increases.

Therefore, when the temperature of the liquid rapidly increases from normal temperature, the dissolution properties are decreased without stopping, and the generation of the UFBs starts. The thermal dissolution properties are decreased as the temperature increases, and a number of the UFBs are generated.

Conversely, when the temperature of the liquid decreases from normal temperature, the dissolution properties of the gas are increased, and the generated UFBs are more likely to be liquefied. However, such temperature is sufficiently lower than normal temperature. Additionally, since the once generated UFBs have a high internal pressure and large gas-liquid interface energy even when the temperature of the liquid decreases, it is highly unlikely that there is exerted a sufficiently high pressure to break such a gas-liquid interface. In other words, the once generated UFBs do not disappear easily as long as the liquid is stored at normal temperature and normal pressure.

In this embodiment, the first UFBs 11A described with Figs. 7A to 7C and the third UFBs 11C described with Figs. 9A to 9C can be described as UFBs that are generated by utilizing such thermal dissolution properties of gas.

On the other hand, in the relationship between the pressure and the dissolution properties of liquid, the higher the pressure of the liquid, the higher the dissolution properties of the gas, and the lower the pressure, the lower the dissolution properties. In other words, the phase transition to the gas of the gas-dissolved liquid dissolved in the liquid is prompted and the generation of the UFBs becomes easier as the pressure of the liquid is lower. Once the pressure of the liquid becomes lower than normal pressure, the dissolution properties are decreased instantly, and the generation of the UFBs starts. The pressure dissolution properties are decreased as the pressure decreases, and a number of the UFBs are generated.

Conversely, when the pressure of the liquid increases to be higher than normal pressure, the dissolution properties of the gas are increased, and the generated UFBs are more likely to be liquefied. However, such pressure is sufficiently higher than the atmospheric pressure. Additionally, since the once generated UFBs have a high internal pressure and large gas-liquid interface energy even when the pressure of the liquid increases, it is highly unlikely that there is exerted a sufficiently high pressure to break such a gas-liquid interface. In other words, the once generated UFBs do not disappear easily as long as the liquid is stored at normal temperature and normal pressure.

In this embodiment, the second UFBs 11B described with Figs. 8A to 8C and the fourth UFBs 11D described with Figs. 10A to 10C can be described as UFBs that are generated by utilizing such pressure dissolution properties of gas.

Those first to fourth UFBs generated by different causes are described individually above; however, the above-described generation causes occur simultaneously with the event of the film boiling. Thus, at least two types of the first to the fourth UFBs may be generated at the same time, and these generation causes may cooperate to generate the UFBs. It should be noted that it is common for all the generation causes to be induced by the film boiling phenomenon. In this specification, the method of generating the UFBs by utilizing the film boiling caused by the rapid heating as described above is referred to as a thermal-ultrafine bubble (T-UFB) generating method. Additionally, the UFBs generated by the T-UFB generating method are referred to as T-UFBs, and the liquid containing the T-UFBs generated by the T-UFB generating method is referred to as a T-UFB-containing liquid.

Almost all the air bubbles generated by the T-UFB generating method are 1.0 μm or less, and milli-bubbles and microbubbles are unlikely to be generated. That is, the T-UFB generating method allows dominant and efficient generation of the UFBs. Additionally, the T-UFBs generated by the T-UFB generating method have larger gas-liquid interface energy than that of the UFBs generated by a conventional method, and the T-UFBs do not disappear easily as long as being stored at normal temperature and normal pressure. Moreover, even if new T-UFBs are generated by new film boiling, it is possible to prevent disappearance of the already generated T-UFBs due to the impact from the new generation. That is, it can be said that the number and the concentration of the T-UFBs contained in the T-UFB-containing liquid have the hysteresis properties depending on the number of times the film boiling is made in the T-UFB-containing liquid. In other words, it is possible to adjust the concentration of the T-UFBs contained in the T-UFB-containing liquid by controlling the number of the heating elements provided in the T-UFB generating unit 300 and the number of the voltage pulse application to the heating elements.

Reference to Fig. 1 is made again. Once the T-UFB-containing liquid W with a desired UFB concentration is generated in the T-UFB generating unit 300, the UFB-containing liquid W is supplied to the post-processing unit 400.

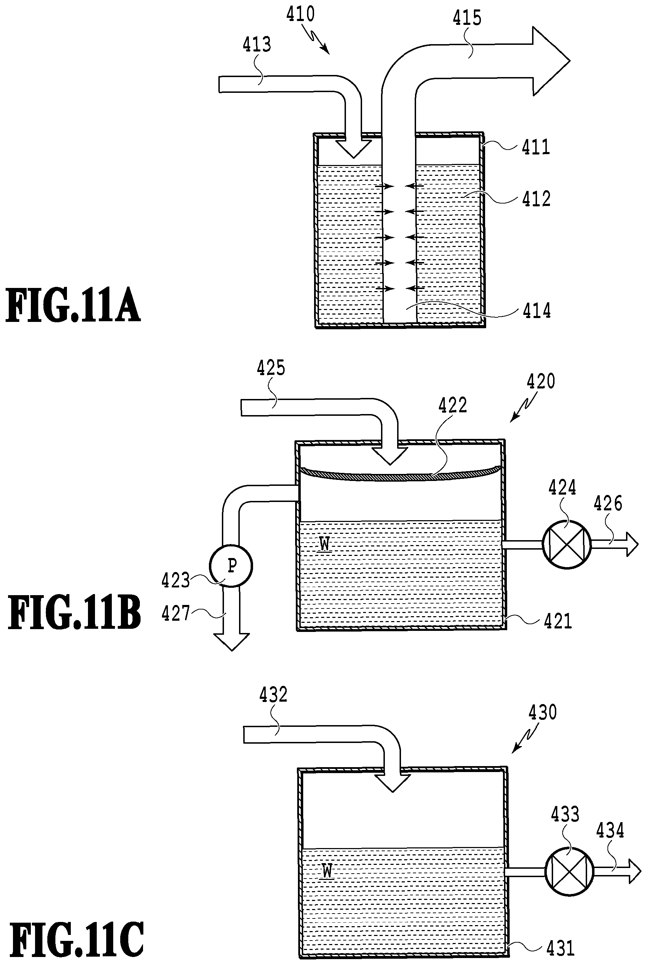

Figs. 11A to 11C are diagrams illustrating configuration examples of the post-processing unit 400 of this embodiment. The post-processing unit 400 of this embodiment removes impurities in the UFB-containing liquid W in stages in the order from inorganic ions, organic substances, and insoluble solid substances.

Fig. 11A illustrates a first post-processing mechanism 410 that removes the inorganic ions. The first post-processing mechanism 410 includes an exchange container 411, cation exchange resins 412, a liquid introduction passage 413, a collecting pipe 414, and a liquid discharge passage 415. The exchange container 411 stores the cation exchange resins 412. The UFB-containing liquid W generated by the T-UFB generating unit 300 is injected to the exchange container 411 through the liquid introduction passage 413 and absorbed into the cation exchange resins 412 such that the cations as the impurities are removed. Such impurities include metal materials peeled off from the element substrate 12 of the T-UFB generating unit 300, such as $SiO_2$, SiN, SiC, Ta, $Al_2O_3$, $Ta_2O_5$, and Ir.

The cation exchange resins 412 are synthetic resins in which a functional group (ion exchange group) is introduced in a high polymer matrix having a three-dimensional network, and the appearance of the synthetic resins are spherical particles of around 0.4 to 0.7 mm. A general high polymer matrix is the styrene-divinylbenzene copolymer, and the functional group may be that of methacrylic acid series and acrylic acid series, for example. However, the above material is an example. As long as the material can remove desired inorganic ions effectively, the above material can be changed to various materials. The UFB-containing liquid W absorbed in the cation exchange resins 412 to remove the inorganic ions is collected by the collecting pipe 414 and transferred to the next step through the liquid discharge passage 415. In this process in the present embodiment, not all the inorganic ions contained in the UFB-containing liquid W supplied from the liquid introduction passage 413 need to be removed as long as at least a part of the inorganic ions are removed.

Fig. 11B illustrates a second post-processing mechanism 420 that removes the organic substances. The second post-processing mechanism 420 includes a storage container 421, a filtration filter 422, a vacuum pump 423, a valve 424, a liquid introduction passage 425, a liquid discharge passage 426, and an air suction passage 427. Inside of the storage container 421 is divided into upper and lower two regions by the filtration filter 422. The liquid introduction passage 425 is connected to the upper region of the upper and lower two regions, and the air suction passage 427 and the liquid discharge passage 426 are connected to the lower region thereof. Once the vacuum pump 423 is driven with the valve 424 closed, the air in the storage container 421 is discharged through the air suction passage 427 to make the pressure inside the storage container 421 negative pressure, and the UFB-containing liquid W is thereafter introduced from the liquid introduction passage 425. Then, the UFB-containing liquid W from which the impurities are removed by the filtration filter 422 is reserved into the storage container 421.

The impurities removed by the filtration filter 422 include organic materials that may be mixed at a tube or each unit, such as organic compounds including silicon, siloxane, and epoxy, for example. A filter film usable for the filtration filter 422 includes a filter of a sub-$\mu$m-mesh (a filter of 1 $\mu$m or smaller in mesh diameter) that can remove bacteria, and a filter of a nm-mesh that can remove virus. The filtration filter having such a fine opening diameter may remove air bubbles larger than the opening diameter of the filter. Particularly, there may be the case where the filter is clogged by the fine air bubbles adsorbed to the openings (mesh) of the filter, which may slowdown the filtering speed. However, as described above, most of the air bubbles generated by the T-UFB generating method described in the present embodiment of the invention are in the size of 1 $\mu$m or smaller in diameter, and milli-bubbles and microbubbles are not likely to be generated. That is, since the probability of generating milli-bubbles and microbubbles is extremely low, it is possible to suppress the slowdown in the filtering speed due to the adsorption of the air bubbles to the filter. For this reason, it is favorable to apply the filtration filter 422 provided with the filter of 1 $\mu$m or smaller in mesh diameter to the system having the T-UFB generating method.

Examples of the filtration applicable to this embodiment may be a so-called dead-end filtration and cross-flow filtration. In the dead-end filtration, the direction of the flow of the supplied liquid and the direction of the flow of the filtration liquid passing through the filter openings are the same, and specifically, the directions of the flows are made along with each other. In contrast, in the cross-flow filtration, the supplied liquid flows in a direction along a filter surface, and specifically, the direction of the flow of the supplied liquid and the direction of the flow of the filtration liquid passing through the filter openings are crossed with each other. It is preferable to apply the cross-flow filtration to suppress the adsorption of the air bubbles to the filter openings.

After a certain amount of the UFB-containing liquid W is reserved in the storage container 421, the vacuum pump 423 is stopped and the valve 424 is opened to transfer the T-UFB-containing liquid in the storage container 421 to the next step through the liquid discharge passage 426. Although the vacuum filtration method is employed as the method of removing the organic impurities herein, a gravity filtration method and a pressurized filtration can also be employed as the filtration method using a filter, for example.

Fig. 11C illustrates a third post-processing mechanism 430 that removes the insoluble solid substances. The third post-processing mechanism 430 includes a precipitation container 431, a liquid introduction passage 432, a valve 433, and a liquid discharge passage 434.

First, a predetermined amount of the UFB-containing liquid W is reserved into the precipitation container 431 through the liquid introduction passage 432 with the valve 433 closed, and leaving it for a while. Meanwhile, the solid substances in the UFB-containing liquid W are precipitated onto the bottom of the precipitation container 431 by gravity. Among the bubbles in the UFB-containing liquid, relatively large bubbles such as microbubbles are raised to the liquid surface by the buoyancy and also removed from the UFB-containing liquid. After a lapse of sufficient time, the valve 433 is opened, and the UFB-containing liquid W from which the solid substances and large bubbles are removed is transferred to the collecting unit 500 through the liquid discharge passage 434. The example of applying the three post-processing mechanisms in sequence is shown in this embodiment; however, it is not limited thereto, and the order of the three post-processing mechanisms may be changed, or at least one needed post-processing mechanism may be employed.

Reference to Fig. 1 is made again. The T-UFB-containing liquid W from which the impurities are removed by the post-processing unit 400 may be directly transferred to the collecting unit 500 or may be put back to the dissolving unit 200 again. In the latter case, the gas dissolution concentration of the T-UFB-containing liquid W that is decreased due to the generation of the T-UFBs can be compensated to the saturated state again by the dissolving unit 200. If new T-UFBs are generated by the T-UFB generating unit 300 after the compensation, it is possible to further increase the concentration of the UFBs contained in the T-UFB-containing liquid with the above-described properties. That is, it is possible to increase the concentration of the contained UFBs by the number of circulations through the dissolving unit 200, the T-UFB generating unit 300, and the post-processing unit 400, and it is possible to transfer the UFB-containing liquid W to the collecting unit 500 after a predetermined concentration of the contained UFBs is obtained. This embodiment shows a form in which the UFB-containing liquid processed by the post-processing unit 400 is put back to the dissolving unit 200 and circulated; however, it is not limited thereto, and the UFB-containing liquid after passing through the T-UFB generating unit may be put back again to the dissolving unit 200 before being supplied to the post-processing unit 400 such that the post-processing is performed by the post-processing unit 400 after the T-UFB concentration is increased through multiple times of circulation, for example.

The collecting unit 500 collects and preserves the UFB-containing liquid W transferred from the post-processing unit 400. The T-UFB-containing liquid collected by the collecting unit 500 is a UFB-containing liquid with high purity from which various impurities are removed.

In the collecting unit 500, the UFB-containing liquid W may be classified by the size of the T-UFBs by performing some stages of filtration processing. Since it is expected that the temperature of the T-UFB-containing liquid W obtained by the T-UFB method is higher than normal temperature, the collecting unit 500 may be provided with a cooling unit. The cooling unit may be provided to a part of the post-processing unit 400.

The schematic description of the UFB generating apparatus 1 is given above; however, it is needless to say that the illustrated multiple units can be changed, and not all of them need to be prepared. Depending on the type of the liquid W and the gas G to be used and the intended use of the T-UFB-containing liquid to be generated, a part of the above-described units may be omitted, or another unit other than the above-described units may be added.

For example, when the gas to be contained by the UFBs is the atmospheric air, the degassing unit as the pre-processing unit 100 and the dissolving unit 200 can be omitted. On the other hand, when multiple kinds of gases are desired to be contained by the UFBs, another dissolving unit 200 may be added.

The units for removing the impurities as described in Figs. 11A to 11C may be provided upstream of the T-UFB generating unit 300 or may be provided both upstream and downstream thereof. When the liquid to be supplied to the UFB generating apparatus is tap water, rain water, contaminated water, or the like, there may be included organic and inorganic impurities in the liquid. If such a liquid W including the impurities is supplied to the T-UFB generating unit 300, there is a risk of deteriorating the heating element 10 and inducing the salting-out phenomenon. With the mechanisms as illustrated in Figs. 11A to 11C provided upstream of the T-UFB generating unit 300, it is possible to remove the above-described impurities previously.

<<Liquid and Gas Usable For T-UFB-Containing Liquid>>

Now, the liquid W usable for generating the T-UFB-containing liquid is described. The liquid W usable in this embodiment is, for example, pure water, ion exchange water, distilled water, bioactive water, magnetic active water, lotion, tap water, sea water, river water, clean and sewage water, lake water, underground water, rain water, and so on. A mixed liquid containing the above liquid and the like is also usable. A mixed solvent containing water and soluble organic solvent can be also used. The soluble organic solvent to be used by being mixed with water is not particularly limited; however, the followings can be a specific example thereof. An alkyl alcohol group of the carbon number of 1 to 4 including methyl alcohol, ethyl alcohol, n-propyl alcohol, isopropyl alcohol, n-butyl alcohol, sec-butyl alcohol, and tert-butyl alcohol. An amide group including N-methyl-2-pyrrolidone, 2-pyrrolidone, 1,3-dimethyl-2-imidazolidinone, N,N-dimethylformamide, and N,N-dimethylacetamide. A keton group or a ketoalcohol group including acetone and diacetone alcohol. A cyclic ether group including tetrahydrofuran and dioxane. A glycol group including ethylene glycol, 1,2-propylene glycol, 1,3-propylene glycol, 1,2-butanediol, 1,3-butanediol, 1,4-butanediol, 1,5-pentanediol, 1,2-hexanediol, 1,6-hexanediol, 3-methyl-1,5-pentanediol, diethylene glycol, triethylene glycol, and thiodiglycol. A group of lower alkyl ether of polyhydric alcohol including ethylene glycol monomethyl ether, ethylene glycol monoethyl ether, ethylene glycol monobutyl ether, diethylene glycol monomethyl ether, diethylene glycol monoethyl ether, diethylene glycol monobutyl ether, triethylene glycol monomethyl ether, triethylene glycol monoethyl ether, and triethylene glycol monobutyl ether. A polyalkylene glycol group including polyethylene glycol and polypropylene glycol. A triol group including glycerin, 1,2,6-hexanetriol, and trimethylolpropane. These soluble organic solvents can be used individually, or two or more of them can be used together.

A gas component that can be introduced into the dissolving unit 200 is, for example, hydrogen, helium, oxygen, nitrogen, methane, fluorine, neon, carbon dioxide, ozone, argon, chlorine, ethane, propane, air, and so on. The gas component may be a mixed gas containing some of the above. Additionally, it is not necessary for the dissolving unit 200 to dissolve a substance in a gas state, and the dissolving unit 200 may fuse a liquid or a solid containing desired components into the liquid W. The dissolution in this case may be spontaneous dissolution, dissolution caused by pressure application, or dissolution caused by hydration, ionization, and chemical reaction due to electrolytic dissociation.

<<Effects of T-UFB Generating Method>>

Next, the characteristics and the effects of the above-described T-UFB generating method are described by comparing with a conventional UFB generating method. For example, in a conventional air bubble generating apparatus as represented by the Venturi method, a mechanical depressurizing structure such as a depressurizing nozzle is provided in a part of a flow passage. A liquid flows at a predetermined pressure to pass through the depressurizing structure, and air bubbles of various sizes are generated in a downstream region of the depressurizing structure.

In this case, among the generated air bubbles, since the relatively large bubbles such as milli-bubbles and microbubbles are affected by the buoyancy, such bubbles rise to the liquid surface and disappear. Even the UFBs that are not affected by the buoyancy may also disappear with the milli-bubbles and microbubbles since the gas-liquid interface energy of the UFBs is not very large. Additionally, even if the above-described depressurizing structures are arranged in series, and the same liquid flows through the depressurizing structures repeatedly, it is impossible to store for a long time the UFBs of the number corresponding to the number of repetitions. In other words, it has been difficult for the UFB-containing liquid generated by the conventional UFB generating method to maintain the concentration of the contained UFBs at a predetermined value for a long time.

In contrast, in the T-UFB generating method of this embodiment utilizing the film boiling, a rapid temperature change from normal temperature to about 300°C and a rapid pressure change from normal pressure to around a several megapascal occur locally in a part extremely close to the heating element. The heating element is a rectangular shape having one side of around several tens to hundreds of $\mu$m. It is around 1/10 to 1/1000 of the size of a conventional UFB generating unit. Additionally, with the gas-dissolved liquid within the extremely thin film region of the film boiling bubble surface exceeding the thermal dissolution limit or the pressure dissolution limit instantaneously (in an extremely short time under microseconds), the phase transition occurs and the gas-dissolved liquid is precipitated as the UFBs. In this case, the relatively large bubbles such as milli-bubbles and microbubbles are hardly generated, and the liquid contains the UFBs of about 100 nm in diameter with extremely high purity. Moreover, since the T-UFBs generated in this way have sufficiently large gas-liquid interface energy, the T-UFBs are not broken easily under the normal environment and can be stored for a long time.

Particularly, the present discloser using the film boiling phenomenon that enables local formation of a gas interface in the liquid can form an interface in a part of the liquid close to the heating element without affecting the entire liquid region, and a region on which the thermal and pressure actions performed can be extremely local. As a result, it is possible to stably generate desired UFBs. With further more conditions for generating the UFBs applied to the generation liquid through the liquid circulation, it is possible to additionally generate new UFBs with small effects on the already-made UFBs. As a result, it is possible to produce a UFB liquid of a desired size and concentration relatively easily.

Moreover, since the T-UFB generating method has the above-described hysteresis properties, it is possible to increase the concentration to a desired concentration while keeping the high purity. In other words, according to the T-UFB generating method, it is possible to efficiently generate a long-time storable UFB-containing liquid with high purity and high concentration.

<<Specific Usage of T-UFB-Containing Liquid>>

In general, applications of the ultrafine bubble-containing liquids are distinguished by the type of the containing gas. Any type of gas can make the UFBs as long as an amount of around PPM to BPM of the gas can be dissolved in the liquid. For example, the ultrafine bubble-containing liquids can be applied to the following applications.

- A UFB-containing liquid containing air can be preferably applied to cleansing in the industrial, agricultural and fishery, and medical scenes and the like, and to cultivation of plants and agricultural and fishery products.
- A UFB-containing liquid containing ozone can be preferably applied to not only cleansing application in the industrial, agricultural and fishery, and medical scenes and the like, but to also applications intended to disinfection, sterilization, and decontamination, and environmental cleanup of drainage and contaminated soil, for example.
- A UFB-containing liquid containing nitrogen can be preferably applied to not only cleansing application in the industrial, agricultural and fishery, and medical scenes and the like, but to also applications intended to disinfection, sterilization, and decontamination, and environmental cleanup of drainage and contaminated soil, for example.
- A UFB-containing liquid containing oxygen can be preferably applied to cleansing application in the industrial, agricultural and fishery, and medical scenes and the like, and to cultivation of plants and agricultural and fishery products.
- A UFB-containing liquid containing carbon dioxide can be preferably applied to not only cleansing application in the industrial, agricultural and fishery, and medical scenes and the like, but to also applications intended to disinfection, sterilization, and decontamination, for example.
- A UFB-containing liquid containing perfluorocarbons as a medical gas can be preferably applied to ultrasonic diagnosis and treatment. As described above, the UFB-containing liquids can exert the effects in various fields of medical, chemical, dental, food, industrial, agricultural and fishery, and so on.

In each of the applications, the purity and the concentration of the UFBs contained in the UFB-containing liquid are important for quickly and reliably exert the effect of the UFB-containing liquid. In other words, unprecedented effects can be expected in various fields by utilizing the T-UFB generating method of this embodiment that enables generation of the UFB-containing liquid with high purity and desired concentration. Here is below a list of the applications in which the T-UFB generating method and the T-UFB-containing liquid are expected to be preferably applicable.

(A) Liquid Purification Application

- With the T-UFB generating unit provided to a water clarification unit, enhancement of an effect of water clarification and an effect of purification of PH adjustment liquid is expected. The T-UFB generating unit may also be provided to a carbonated water server.
- With the T-UFB generating unit provided to a humidifier, aroma diffuser, coffee maker, and the like, enhancement of a humidifying effect, a deodorant effect, and a scent spreading effect in a room is expected.
- If the UFB-containing liquid in which an ozone gas is dissolved by the dissolving unit is generated and is used for dental treatment, burn treatment, and wound treatment using an endoscope, enhancement of a medical cleansing effect and an antiseptic effect is expected.
- With the T-UFB generating unit provided to a water storage tank of a condominium, enhancement of a water clarification effect and chlorine removing effect of drinking water to be stored for a long time is expected.
- If the T-UFB-containing liquid containing ozone or carbon dioxide is used for brewing process of Japanese sake, shochu, wine, and so on in which the high-temperature pasteurization processing cannot be performed, more efficient pasteurization processing than that with the conventional liquid is expected.
- If the UFB-containing liquid is mixed into the ingredient in a production process of the foods for specified health use and the foods with functional claims, the pasteurization processing is possible, and thus it is possible to provide safe and functional foods without a loss of flavor.
- With the T-UFB generating unit provided to a supplying route of sea water and fresh water for cultivation in a cultivation place of fishery products such as fish and pearl, prompting of spawning and growing of the fishery products is expected.
- With the T-UFB generating unit provided in a purification process of water for food preservation, enhancement of the preservation state of the food is expected.
- With the T-UFB generating unit provided in a bleaching unit for bleaching pool water or underground water, a higher bleaching effect is expected.
- With the T-UFB-containing liquid used for repairing a crack of a concrete member, enhancement of the effect of crack repairment is expected.

- With the T-UFBs contained in liquid fuel for a machine using liquid fuel (such as automobile, vessel, and airplane), enhancement of energy efficiency of the fuel is expected.

(B) Cleansing Application

Recently, the UFB-containing liquids have been receiving attention as cleansing water for removing soils and the like attached to clothing. If the T-UFB generating unit described in the above embodiment is provided to a washing machine, and the UFB-containing liquid with higher purity and better permeability than the conventional liquid is supplied to the washing tub, further enhancement of detergency is expected.

- With the T-UFB generating unit provided to a bath shower and a bedpan washer, not only a cleansing effect on all kinds of animals including human body but also an effect of prompting contamination removal of a water stain and a mold on a bathroom and a bedpan are expected.
- With the T-UFB generating unit provided to a window washer for automobiles, a high-pressure washer for cleansing wall members and the like, a car washer, a dishwasher, a food washer, and the like, further enhancement of the cleansing effects thereof is expected.
- With the T-UFB-containing liquid used for cleansing and maintenance of parts produced in a factory including a burring step after pressing, enhancement of the cleansing effect is expected.
- In production of semiconductor elements, if the T-UFB-containing liquid is used as polishing water for a wafer, enhancement of the polishing effect is expected. Additionally, if the T-UFB-containing liquid is used in a resist removal step, prompting of peeling of resist that is not peeled off easily is enhanced.
- With the T-UFB generating unit is provided to machines for cleansing and decontaminating medical machines such as a medical robot, a dental treatment unit, an organ preservation container, and the like, enhancement of the cleansing effect and the decontamination effect of the machines is expected. The T-UFB generating unit is also applicable to treatment of animals.

(C) Pharmaceutical Application

- If the T-UFB-containing liquid is contained in cosmetics and the like, permeation into subcutaneous cells is prompted, and additives that give bad effects to skin such as preservative and surfactant can be reduced greatly. As a result, it is possible to provide safer and more functional cosmetics.
- If a high concentration nanobubble preparation containing the T-UFBs is used for contrasts for medical examination apparatuses such as a CT and an MRI, reflected light of X-rays and ultrasonic waves can be efficiently used. This makes it possible to capture a more detailed image that is usable for initial diagnosis of a cancer and the like.
- If a high concentration nanobubble water containing the T-UFBs is used for a ultrasonic wave treatment machine called high-intensity focused ultrasound (HIFU), the irradiation power of ultrasonic waves can be reduced, and thus the treatment can be made more non-invasive. Particularly, it is possible to reduce the damage to normal tissues.
- It is possible to create a nanobubble preparation by using high concentration nanobubbles containing the T-UFBs as a source, modifying a phospholipid forming a liposome in a negative electric charge region around the air bubble, and applying various medical substances (such as DNA and RNA) through the phospholipid.
- If a drug containing high concentration nanobubble water made by the T-UFB generation is transferred into a dental canal for regenerative treatment of pulp and dentine, the drug enters deeply a dentinal tubule by the permeation effect of the nanobubble water, and the decontamination effect is prompted. This makes it possible to treat the infected root canal of the pulp safely in a short time.

<<Layout of Element Substrate>>

As described above, the UFBs 11 are generated by the film boiling generated by applying a predetermined voltage pulse to one heating element (hereinafter, also referred to as heater)10. Therefore, the number of the UFBs 11 generated in a predetermined unit time can be increased by increasing the number of the heating elements 10. In order to generate the desired number of the UFBs 11 stably in a short time, it is required to arrange many heating elements densely to be driven. As an example, there may be considered an embodiment of the UFB generating apparatus 1 in which multiple element substrates 12 each including the multiple heating elements 10 arranged thereon are laid out such that 10,000 pieces of the heating elements 10 are arranged. In the case of attempting to generate the UFBs 11 in a shorter time, it is required to further increase the number of the heating elements 10.

However, it is impossible in some cases to stably generate the UFBs 11 by only increasing the number of the heating elements 10 simply. For example, in the case where the number of the heating elements 10 is more than 10,000 pieces, the total currents flowing through those heating elements 10 is an enormous value. Additionally, for example, the parasitic resistance losses in wirings for connecting to the heating elements 10 are varied depending on the heating elements 10. For this reason, the energies inputted to the heating elements 10 are varied greatly. With the energies inputted to the heating elements 10 varied greatly, there is a risk of appearance of a heating element 10 to which an energy exceeding the allowable range is inputted. In the case of arranging a number of the heating elements 10 densely on the element substrate 12 to stably generate a great amount of the UFBs, the variation of energies inputted to the heating elements 10 is required to be maintained within a predetermined range. Hereinafter, first, the situation where the energies inputted to the heating elements 10 are varied is described.

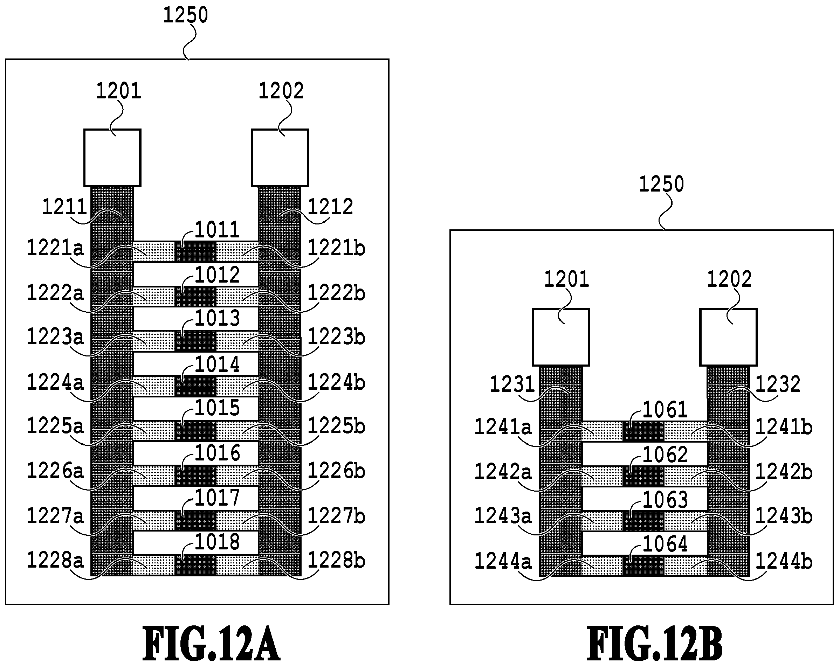

Figs. 12A and 12B are diagrams illustrating examples of a planar layout extracting an element region 1250 (also referred to as a heating part), which is a part of the element substrate 12, and illustrating examples where multiple heating elements are provided in each element region 1250. Fig. 12A is an example where eight heating elements 1011 to 1018 are arranged on one element region 1250, and Fig. 12B is an example where four heating elements 1061 to 1064 are arranged on one element region 1250. Hereinafter, the description is given with the example of the smaller number of the heating elements for the sake of description.

In Fig. 12A, electrode pads 1201 and 1202 are arranged in the element region 1250 for applying electric energy to each of the eight heating elements 1011 to 1018. In other words, the element region 1250 may be understood as an aggregate of two or more heating elements to which the energies are inputted by the pair of electrode pads. Regions 1221a to 1228a and 1221b to 1228b are individual wiring regions connected to the heating elements 1011 to 1018, respectively. Regions 1211 and 1212 are common wiring regions connecting the multiple individual wiring regions with the electrode pads 1201 and 1202. The heating elements 1011 to 1018 used in this embodiment are produced to have substantially the same shape and film thickness by forming through the step of semiconductor photolithography. That is, the heating elements 1011 to 1018 have substantially the same resistance values.

Unless otherwise stated, the heating elements 10 generating the UFBs have substantially the same shape and have substantially the same resistance value in the initial state in the following description. The shapes of the heating elements 10 may not necessarily be the same shape, and the configuration is not limited as long as it is configured to suppress the variation of the energies as described below. For example, the shapes of the heating elements 10 may be different for each element region 1250. Partial changing of the shapes of the heating elements 10 can be performed as necessary by mask designing in the step of photolithography.

The currents flow through the common wiring regions 1211 and 1212, the individual wiring regions 1221 to 1228, and the heating elements 1011 to 1018 by applying the voltage pulses illustrated in Fig. 6A to the electrode pads 1201 and 1202. Then, the film boiling is generated in the liquid on each of the heating elements 1011 to 1018, and the UFBs are thus generated.

Unlike Fig. 12A, Fig. 12B is an example where four heating elements 1061 to 1064 are arranged in the element region 1250. Regions 1241a to 1244a and 1241b to 1244b are individual wiring regions connected to the corresponding heating elements 1061 to 1064 individually. Regions 1231 and 1232 are common wiring regions connecting the multiple individual wiring regions with the electrode pads 1201 and 1202.

The inventor found that the amount of the UFBs generated by each heating element in the configuration illustrated in Fig. 12A and the amount of the UFBs generated by each heating element in the configuration illustrated in Fig. 12B are different. This is because there is a difference occurs between the amount of energy consumed by each of the heating elements 1011 to 1018 in the configuration of Fig. 12A and the amount of energy consumed by each of the heating elements 1061 to 1064 in the configuration of Fig. 12B. Specifically, the wiring resistance losses in the common wiring regions 1211, 1212, 1231 and 1232 cause the variation of energies inputted to the heating elements and the difference between the amounts of energies.

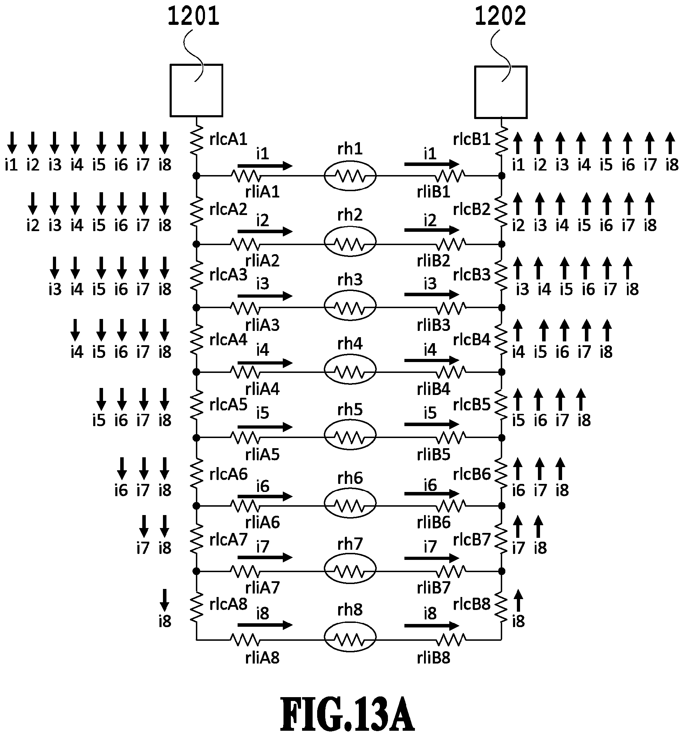

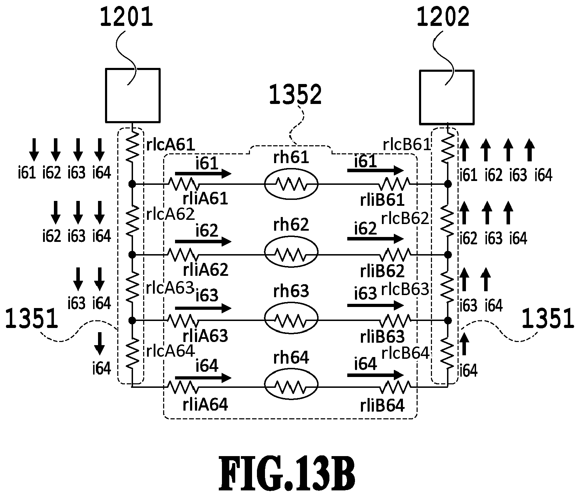

Figs. 13A and 13B are diagrams illustrating electrical equivalent circuits for the configurations in Figs. 12A and 12B. Fig. 13A corresponds to the configuration in Fig. 12A, and Fig. 13B corresponds to the configuration in Fig. 12B. The variation of energies is described in detail with reference to Figs. 12A to 13B.

Figs. 13A and 13B are diagrams in which the individual wiring regions and the common wiring regions in Figs. 12A and 12B are replaced with electric wiring resistances, and the heating elements are replaced with electric heating element resistances. rh1 to rh8 in Fig. 13A represent resistance values of heating elements corresponding to the heating elements 1011 to 1018 in Fig. 12A, and rh61 to rh64 in Fig. 13B represent resistance values of heating elements corresponding to the heating elements 1061 to 1064 in Fig. 12B. rliA1 to rliA8 in Fig. 13A represent resistance values of the individual wiring regions 1221a to 1228a in Fig. 12A. rliB1 to rliB8 in Fig. 13A represent resistance values of the individual wiring regions 1221b to 1228b in Fig. 12A. rlcA1 to rlcA8 in Fig. 13A represent resistance values of the common wiring region 1211 in Fig. 12A. rlcB1 to rlcB8 in Fig. 13A represent resistance values of the common wiring region 1212 in Fig. 12A. Likewise, rliA61 to rliA64 in Fig. 13B represent resistance values of the individual wiring regions 1241a to 1244a in Fig. 12B, and rliB61 to rliB64 represent resistance values of individual wiring regions 1241b to 1244b in Fig.

12B. rlcA61 to rlcA64 represent resistance values of the common wiring region 1231 in Fig. 12B, and rlcB61 to rlcB64 represent resistance values of the common wiring region 1232 in Fig. 12B.

The currents flowing through the heating elements during the application of the voltage pulses (time t1) illustrated in Fig. 6A between the electrode pads 1201 and 1202 are represented by i1 to i8 in Fig. 13A, and the currents are represented by i61 to i64 in Fig. 13B. In Figs. 13A and 13B, the currents i1 to i8 and i61 to i64 flowing through the heating elements are used to indicate the currents flowing in regions of the wiring resistances.

In this case, an energy E1 inputted to the heating element 1011 in Fig. 13A can be expressed by Expression 1, and an energy E2 inputted to the heating element 1018 in Fig. 13A can be expressed by Expression 2:

$$\text{heating element } 1011: E1 = i1 \times i1 \times rh1 \times t1 \text{ (Expression 1)};$$

and

$$\text{heating element } 1018: E2 = i8 \times i8 \times rh8 \times t1 \text{ (Expression 2)}.$$

Additionally, an energy E3 inputted to the heating element 1061 in Fig. 13B can be expressed by Expression 3, and an energy E4 inputted to the heating element 1064 in Fig. 13B can be expressed by Expression 4:

$$\text{heating element } 1061: E3 = i61 \times i61 \times rh61 \times t1 \text{ (Expression 3)};$$

and

$$\text{heating element } 1064: E4 = i64 \times i64 \times rh64 \times t1 \text{ (Expression 4)}.$$

Since the heating elements in this case are formed simultaneously in the step of photolithography, the resistance values rh1, rh8, rh61 and rh64 of the heating elements are substantially equal to each other. On the other hand, the currents flowing through the heating elements are i1 ≠ i8 ≠ i61 ≠ i64 mainly due to the effects of the portions of the wiring resistances rlc. This causes the variation of energies applied to the heating elements. Consequently, different amounts of the UFBs are generated depending on the heating elements, and the stable UFB generation is hampered. In order to stably generate the UFBs in a short time, it is required to reduce the variation of energies inputted to the heating elements in the element region.

Example of suppressing the variation of energies applied to the multiple heating elements 10 in configurations including the heating elements 10 are described below.

<Embodiment 1>

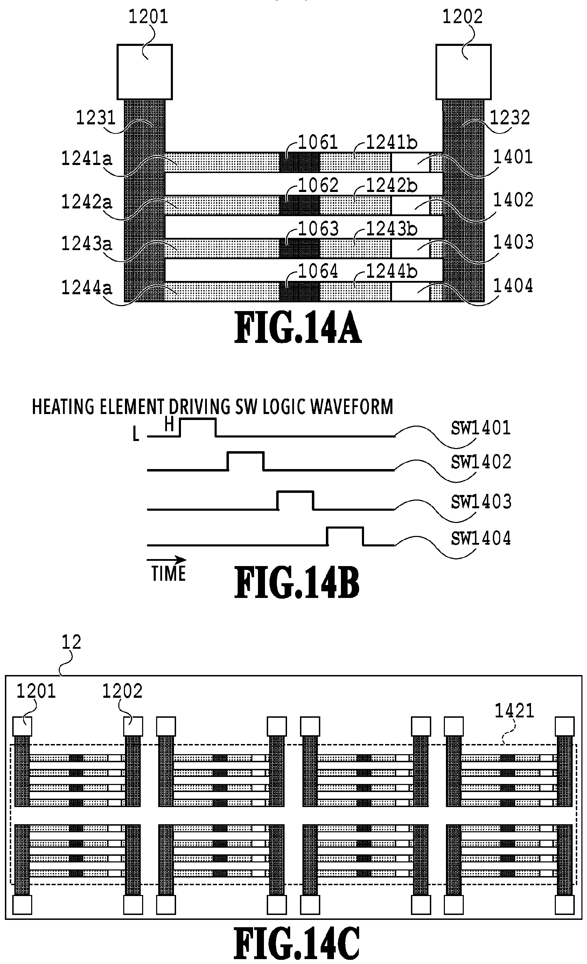

Figs. 14A to 14C are diagrams for describing an example of reducing a difference between the wiring resistance losses in the common wiring regions. Fig. 14A is a diagram corresponding to the configuration of Fig. 12B and illustrating an example of a planar layout extracting an element region, which is a part of the element substrate 12. In the configuration illustrated in Fig. 14A, switches (SW) 1401 to 1404 for controlling the currents flowing through the heating elements are arranged on the individual wiring regions 1241b to 1244b, respectively. In the configuration, although supply voltages (24V) of the heating elements are applied constantly to the electrode pads 1201 and 1202, no currents flow through the heating elements while the SWs are turned off (L). Fig. 14B is a diagram illustrating waveforms of logic signals of the SWs 1401 to 1404 driving the heating elements. With logic signals H applied to each of the SWs 1401 to 1404, the SWs are turned on, currents generated by the supply voltage start to flow into the corresponding heating elements through the electrode pads 1201 and 1202, and the film boiling is generated on each heating element.

The configurations illustrated in Figs. 12A to 13B are configurations of driving all the heating elements connected to the electrode pads simultaneously during the application time of the supply voltages. On the other hand, in the configuration illustrated in Fig. 14A, the heating elements 1061 to 1064 are driven with the SWs 1401 to 1404 shifting the timings of the driving, respectively. Such a configuration makes it possible to considerably reduce the wiring resistance losses in common wiring portions 1351 that are affected in the simultaneous current flows through the multiple heating elements 1061 to 1064 in Fig. 13B. As described above, it is possible to suppress the variation of energies inputted to the heating elements by arranging the SWs 1401 to 1404 to allow the driving of the heating elements in a time division manner.

Fig. 14C is a diagram illustrating an example where multiple element regions illustrated in Fig. 14A are arranged on the element substrate 12. It is required to arrange a lot of heating elements to stably generate the UFBs in a short time. Although Fig. 14C illustrates an embodiment where eight element regions each provided with the four heating elements are arranged for the sake of description, it is still possible to arrange a lot of heating elements by increasing the number of the heating elements in each element region or increasing the number of the element regions. In the T-UFB generating unit 300, walls 1421 and a lid (not illustrated) are provided to cover the heating elements 10 but not to cover the electrode pads 1201 and 1202 on the element substrate 12 to form the liquid chamber. Although no walls for partitioning the inside of the liquid chamber are provided in this embodiment, it is possible to provide the walls for partitioning the inside.

<Embodiment 2>

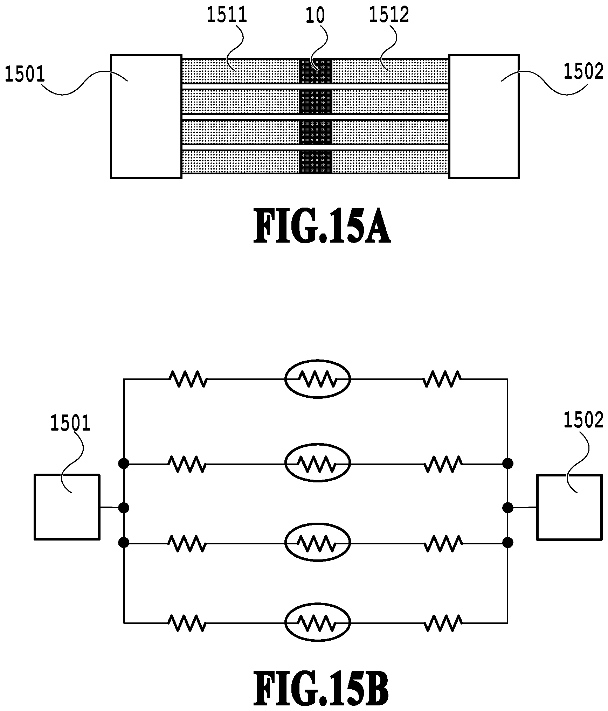

Figs. 15A to 15F are diagrams describing Embodiment 2. Although the embodiment where the SWs are arranged on the element substrate 12 is described with reference to the configuration illustrated in Figs. 14A to 14C, this embodiment is an embodiment where the SWs are provided outside the element substrate 12 to reduce the cost of the element substrate 12. For example, the element region including multiple heating elements and a pair of electrode pads is divided into multiple groups (blocks), and the blocks to be driven can be switched by the SWs. In Embodiment 1, the embodiment where the element substrate 12 is provided with the common wiring regions 1231 and 1232 connecting the multiple heating elements in parallel is described. This embodiment is an embodiment where each heating element 10 is connected to independent individual wirings 1511 and 1512.

Fig. 15A is a diagram illustrating a layout of an element region, and Fig. 15B is an equivalent circuit of Fig. 15A. In Fig. 15A, the supply voltage in a pulse form is applied to each heating element 10 through the electrode pads 1501 and 1502 and corresponding pair of the individual wirings 1511 and 1512, and the heating elements 10 are driven simultaneously. Since the current flows to each of the heating elements 10 through the corresponding pair of the individual wirings 1511 and 1512 in the configuration in Fig. 15A, the variation of energies inputted to the heating elements 10 can be suppressed even in the simultaneous driving of the heating elements 10.

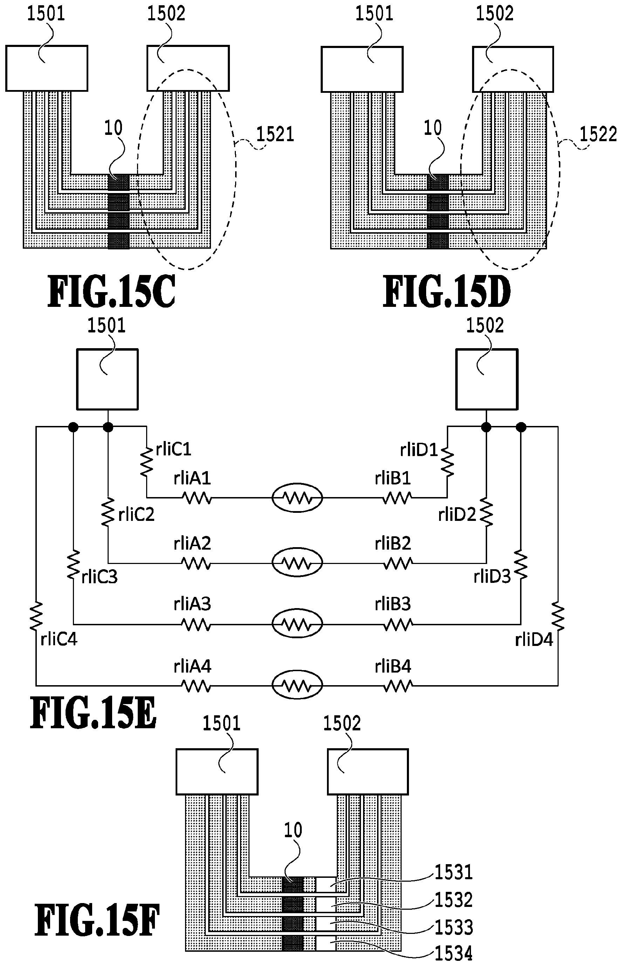

Fig. 15C is a layout diagram in which the positions of the electrode pads 1501 and 1502 are different from the positions in Fig. 15A. The positions of the electrode pads 1501 and 1502 are gathered on one side of the element substrate 12, and thus it is possible to improve the degree of freedom of layout and also to implement a dense configuration. Since the independent individual wirings are connected to the corresponding heating elements 10 in the configuration in Fig. 15C as well, it is still possible to suppress the variation of energies by this configuration itself. However, in the case of arranging more heating elements 10, the lengths of the wirings connected to the heating elements 10 are different from each other depending on the different positions of the heating elements 10 as illustrated in a region 1521. This causes the differences between the wiring resistances, and thus the variation of energies may occur. Specifically, an individual wiring resistance to the heating element 10 arranged far from the electrode pads 1501 and 1502 is greater than an individual wiring resistance to the heating element 10 arranged close to the electrode pads 1501 and 1502. Consequently, the variation of energies flowing through the heating elements may occur depending on the distances from the electrode pads 1501 and 1502.

Fig. 15D is a layout diagram for suppressing the variation of energies more than the configuration in Fig. 15C does. In the configuration illustrated in Fig. 15D, the wiring widths in the region in which the difference between the wiring resistances occurs in the wiring layout as illustrated in the region 1521 in Fig. 15C are widened as illustrated in a region 1522. Such a layout makes it possible to suppress the variation of energies inputted to the heating elements 10. In the example in Fig. 15D, the width of the individual wiring connected to the heating element 10 farther from the electrode pads 1501 and 1502 is made wider than the width of the individual wiring connected to the heating element 10 closer to the electrode pads 1501 and 1502.

Fig. 15E is a diagram illustrating an equivalent circuit of Fig. 15D and is particularly a diagram indicating the wiring resistances corresponding to the difference between the wiring widths. The relationships between the wiring resistances in Fig. 15E are as below:

$$rliA1 < rliA2 < rliA3 < rliA4;$$

$$rliB1 < rliB2 < rliB3 < rliB4;$$

and

$$rliA1 + rliC1 + rliB1 + rliD1 = rliA2 + rliC2 + rliB2 + rliD2 = rliA3 + rliC3 +$$

$$rliB3 + rliD3 = rliA4 + rliC4 + rliB4 + rliD4.$$

Although the above expressions are connected with equal signs, the resistances may be substantially equal to each other as long as each heating element 10 can keep the variation of film boiling generating the UFBs at a predetermined level.

Fig. 15F is a layout illustrating a modification of Fig. 15D. Fig. 15F illustrates an embodiment where SWs 1531 to 1534 are formed on the element substrate 12. The SWs 1531 to 1534 are similar to the SWs described in Embodiment 1. It is possible to further suppress the variation of energies by controlling the driving in the time division manner using the SWs 1531 to 1534 and also making the wiring resistances of the heating elements equal to each other.

<Embodiment 3>

Similar to Embodiment 1, this embodiment has a configuration of providing the common wirings connecting the heating elements in parallel. In Embodiment 1, the embodiment where the variation of energies is suppressed by the control in the time division manner using the SWs to diminish the effect of the parasitic wiring resistances is described. In this embodiment, an embodiment where the supply voltages, the heating element resistances, and the wiring resistances are adjusted to suppress the variation of energies is described.

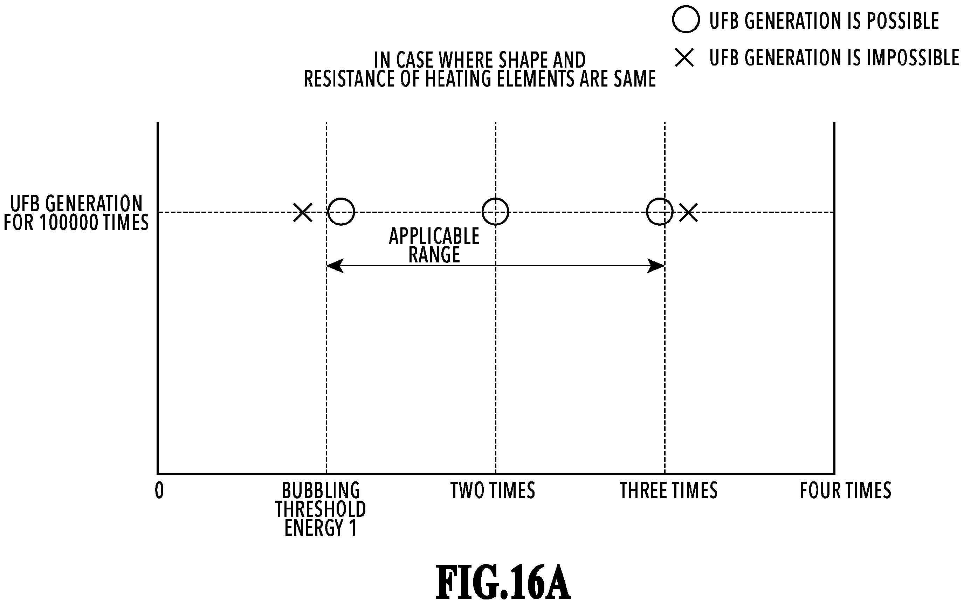

Figs. 16A to 16E are diagrams describing examples of stably generating the UFBs. Fig. 16A is a diagram describing the heating element used in this embodiment. The inventor conducted an experiment by using a heating element capable of generating 100,000 times of film boiling. This heating element was the one guaranteed to generate the film boiling until it reaches 100,000th film boiling. In other words, the heating element had a risk of generating unpreferable film boiling if film boiling was generated 100,000 or more times and the element resistance of the heating element was disconnected, for example.

Fig. 16A indicates the result of the confirmation by the inventor about how much energy was required to be applied to the heating element capable of making 100,000 times of film boiling for generating the UFBs. Fig. 16A indicates that the film boiling was generated in the case where a bubbling threshold energy is "1" (a first value), theoretically. If the inputted energy was changed by changing the supply voltage, and once the inputted energy is increased to be more than 3 times the bubbling threshold energy set to "1", the resistance value of the heating element was changed rapidly during about 100,000 times of application of application pulses, and it was difficult to generate the UFBs. In other words, it was found that it is possible to stably generate the UFBs without a sudden break and the like of a predetermined heating element if the energy inputted to the heating element is 3 times or less the bubbling threshold energy set to "1". In order to stably generate the UFBs by using the heating element generating the film boiling with the bubbling threshold energy set to "1", the smallest value of the energy inputted to the heating element was set to 1.1 times the bubbling threshold energy taking into consideration the variation depending on the environment. In this embodiment, in the case where the bubbling threshold energy is set to "1", the variation of energies inputted to the heating elements preferably falls within a range from 1.1 times the bubbling threshold energy to 3 times the bubbling threshold energy. Although the description is given herein using the heating element capable of generating the film boiling 100,000 times as an example, another heating element having different durability may be applied similarly.

In this embodiment, a specific configuration in which the variation of energies inputted to the heating elements falls within the above-described range is described. In this embodiment, the layouts of Figs. 12B and 13B described in Embodiment 1 are used. In this embodiment, an embodiment where the energies inputted to the heating elements are kept within a predetermined range based on the bubbling threshold energy (from 1.1 times to 3 times) by adjusting the supply voltages, the heating element resistances, and the wiring resistances is described. More specifically, an embodiment of adjusting the wiring resistances is described. This makes it possible to stably generate the UFBs in the case of arranging the heating elements densely, with the layout of the wiring region around the heating elements 10 made compact.

This embodiment focuses on three portions in Fig. 13B, which are a heating element portion 1352, the common wiring portions 1351, and the electrode pads 1201 and 1202. The heating element portion 1352 includes both the heating elements and the individual wiring regions. In the case of arranging the heating elements densely to generate the UFBs in a short time, it is desirable that the region for the individual wiring portion is as small as possible. On the other hand, it is desirable that as many as possible of the heating element portions are connected to the common wiring portion 1351 to arrange the heating elements densely.

In Fig. 13B, i61 to i64 are the currents flowing through the heating elements rh61 to rh64, respectively. As illustrated in Fig. 13B, the energies inputted to the heating elements rh61 to rh64 herein are expressed by $i61 \times i61 \times rh61 \times t1$, $i62 \times i62 \times rh62 \times t1$, $i63 \times i63 \times rh63 \times t1$, $i63 \times i63 \times rh63 \times t1$, respectively. t1 is a pulse width illustrated in Fig. 6A. In this embodiment, the heating elements are formed in the step of photolithography, and the heating elements have the same heating resistances. Thus, the difference between energies inputted to the heating elements is proportional to the square of the current flowing through each heating element.

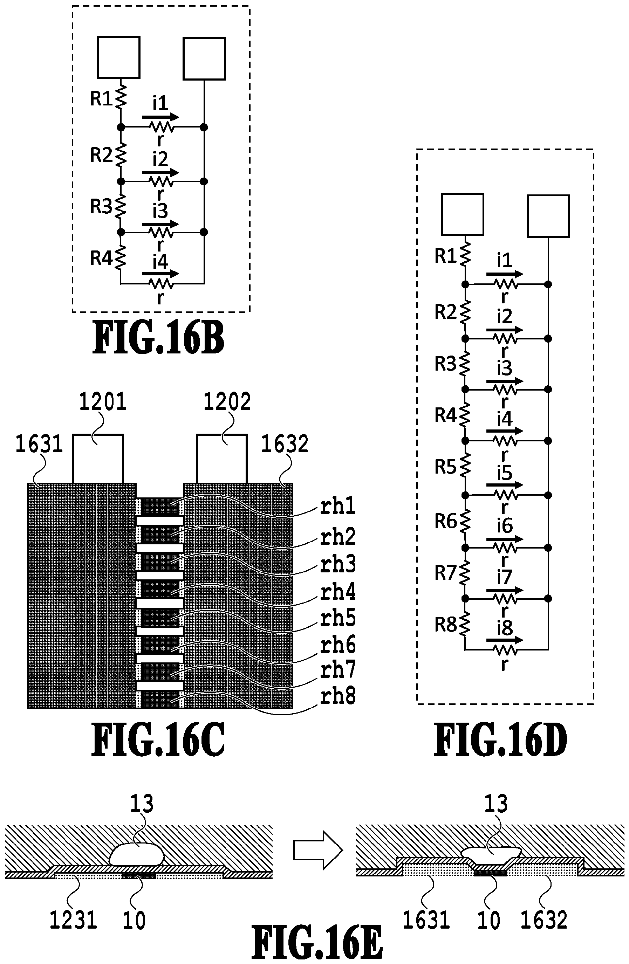

Fig. 16B illustrates an equivalent circuit of Fig. 13B, and is a diagram in which the currents flowing through the heating elements are represented by i1 to i4, the sum of the resistance value of each heating element and the parasitic resistance value of the wiring individually connected to the corresponding heating element is represented by r, and the resistance values in the common wiring portion are represented by R1 to R4.

In the circuit illustrated in Fig. 16B, Expression (5) holds based on the Kirchhoff s circuit laws:

$$
\begin{pmatrix}
R1 + r & R1 & R1 & R1 \\
R1 & R1 + R2 + r & R1 + R2 & R1 + R2 \\
R1 & R1 + R2 & R1 + R2 + R3 + r & R1 + R2 + R3 \\
R1 & R1 + R2 & R1 + R2 + R3 & R1 + R2 + R3 + R4 + r
\end{pmatrix}
\begin{pmatrix} i1 \\ i2 \\ i3 \\ i4 \end{pmatrix}
=
\begin{pmatrix} V1 \\ V1 \\ V1 \\ V1 \end{pmatrix}
$$

Expression (5).

In the case of using the values in Table 1, since the difference between energies inputted to the heating elements is proportional to the square of the current flowing through each heating element, the ratio of the energy inputted to each heating element may be that shown in Table 2.

Table 1

| VI | 24 V |
|---|---|
| r | 200 Ω |
| R1 to R4 | 20 Ω |

Table 2

| Heating element | Ratio of energy inputted to heating element |
|---|---|
| rh61 | 2.9 |
| rh62 | 1.9 |
| rh63 | 1.3 |
| rh64 | 1.1 |

Because of the difference between the wiring resistances, the energy inputted to the heating element rh64 positioned farthest from the electrode pads 1201 and 1202 is the smallest. In this case, as described above, the energies to be inputted are determined such that the energy inputted to the heating element rh64 in the farthest position is 1.1 times the bubbling threshold energy "1", which is the smallest value in the predetermined range. Hereinafter, the ratio of the energy inputted to the heating element (that is 1.1 times the bubbling threshold energy in this example) is simply called an inputted energy ratio.

As shown in Table 1, V1 is set to 24 V, the resistance value r that is the sum of the resistance values of the heating element and the parasitic resistance portion wired individually is set to 200 Ω, and the resistance values R1 to R4 in the portion for the common flow are set to 20 Ω. In this case, with the inputted energy ratio of rh64 set to 1.1, the ratio of the energy inputted to rh61 to which the greatest energy is inputted is set to 2.9. That is, in the case of setting the bubbling threshold energy to "1", the ratio of energy inputted to each heating element can be kept within the range from 1.1 times to 3 times. Such a configuration makes it possible to generate the UFBs by generating a maximum of 100,000 pulses (100,000 times) of heat boiling by each heating element. Specifically, it is possible to stably generate the UFBs by keeping each of the resistance values R1 to R4 in the common flow wiring region to 1/10 or less of the corresponding resistance value r of the individual wiring including the heating element resistance value, as shown in Table 1.

Fig. 16C is an example different from that in Fig. 16B. Fig. 16C illustrates an example where the number of the heating elements is eight. The electric circuit in Fig. 16C can be expressed as the circuit in Fig. 13A. Fig. 16D illustrates an equivalent circuit of Fig. 13A, and is a diagram in which the currents flowing through the heating elements are represented by i1 to i8, the sum of the resistance value of each heating element and the parasitic resistance value of the wiring individually connected to the corresponding heating element is represented by r, and the resistance values in the common wiring portion are represented by R1 to R8.

As described above, the values shown in Table 3 are used, for example, to implement the configuration in which the energy ratio of rh8 to which the smallest heating element input energy is applied is set to 1.1 and the energy ratio of rh1 to which the greatest heating element input energy is applied is set to 2.9 based on the Kirchhoff s circuit laws. In this case, the ratio of energy inputted to each heating element may be that shown in Table 4.

Table 3

| V1 | 20 V |
|---|---|
| r | 200 $\Omega$ |
| R1 to R4 | 4 $\Omega$ |

Table 4

| Heating element | Ratio of energy inputted to heating element |
|---|---|
| rh1 | 2.9 |
| rh2 | 2.3 |
| rh3 | 1.9 |
| rh4 | 1.6 |
| rh5 | 1.4 |
| rh6 | 1.3 |
| rh7 | 1.2 |
| rh8 | 1.1 |

As shown in Table 4, in this example, the supply voltage of the heating element is set to 20 V, the resistance that is the sum of the resistance of the heating element and the resistance of the individual wiring connected to the corresponding heating element is set to 200 $\Omega$, and the parasitic wiring resistances in the common wiring are each set to 4 $\Omega$. In the configuration in Fig. 16B, it is possible to stably generate the UFBs with the parasitic wiring resistance in the common wiring set to 20 $\Omega$ (1/10 of the sum of the resistance values of the individual wirings and the heating elements). On the other hand, in the configuration illustrated in Fig. 16D, the parasitic wiring resistance in the common wiring is required to be set to 4 $\Omega$ (1/50 of the sum of the resistance values of the individual wirings and the heating elements) or less. In the configuration in Fig. 16D, the low resistances of the common wiring portion reducing the entire loss and the supply voltage set to 20 V make it possible to achieve the predetermined energy ratios shown in Table 4.

Although the descriptions are given with the two specific examples, there may be considered various variations depending on the number of the heating elements. In any case, any configuration may be applicable as long as the energies inputted to the heating elements fall within the predetermined range of the input energy ratio (from 1.1 times to 3 times). As illustrated in Fig. 16C, in order to suppress the variation of energies inputted to the heating elements, it is possible to reduce the parasitic wiring resistances in the common wirings by widening the wiring widths of common wiring regions 1631 and 1632. Alternatively, as illustrated in Fig. 16E, it is possible to reduce the parasitic wiring resistances in the common wirings by providing the common wiring regions 1631 and 1632 having the film thicknesses of wiring resistance layers greater than that of the common wiring regions 1231 and 1232. That is, the width or the film thickness of the common wiring may be set such that the amount of the resistance value in the common wiring is at a predetermined ratio or less to the sum of the resistance of the heating element and the resistance of the wiring individually connected to the corresponding heating element.

<Modification 1>

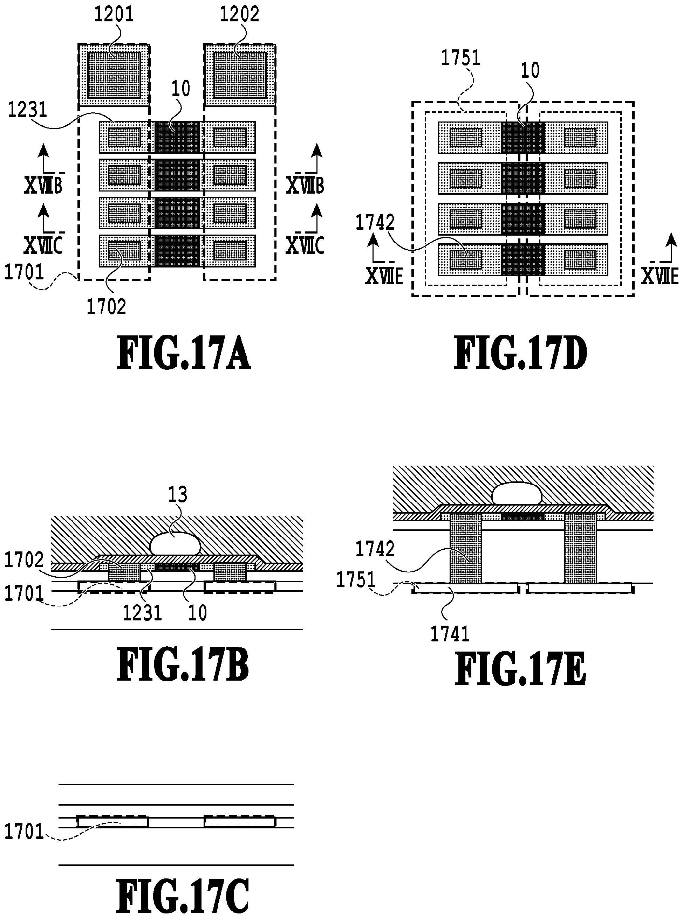

Figs. 17A to 17G are diagrams describing various modifications of stably generating the UFBs. In Figs. 16A to 16E, the embodiment where the entire loss can be suppressed by reducing the resistances in the common wiring portions and consequently the variation of energies inputted to the heating elements is suppressed is described. In order to arrange the heating elements further densely, making the wiring regions individually connected to the heating elements as small as possible is effective.

Figs. 17A to 17C are diagrams illustrating an example of forming multiple wiring layers. Fig. 17A is a planar layout diagram, and Figs. 17B and 17C are a cross-sectional view taken along the XVIIB-XVIIB line and a cross-sectional view taken along the XVIIC-XVIIC line, respectively. It is possible to achieve downsizing while reducing the values of the common wiring resistances by forming a wiring layer to be used as the common wiring portion, which is different from the above-described wiring layers connecting the heating elements. In Figs. 17A to 17C, a wiring layer 1701 is a layer different from the layer of the common wiring region 1231 connected to the heating elements 10. A through-hole 1702 electrically connects the layer of the common wiring region 1231 connected to the heating elements 10 with the wiring layer 1701.

In the embodiment in Figs. 17A to 17C, an embodiment where the wiring layer 1701 is not arranged on a lower layer portion under the heating element 10 taking into consideration the effect of heat stress from the heating elements 10 is illustrated. However, if the configuration includes a barrier layer or the like formed on the top of the wiring layer to suppress the heat stress, the wiring layer 1701 may be extended to the lower layer portion under the heating element 10. Although the embodiment of forming the wiring layer 1701 as a new layer is described in the embodiment in Figs. 17A to 17C, more wiring layers may be provided additionally in the case where more heating elements are provided to achieve higher density. It is possible to reduce the wiring resistances by increasing the film thickness of the wiring directly connected to the heating elements 10 as described with reference to Fig. 16E; however, in this case, the shapes of the heating elements arranged on the same layer may be varied during pattern etching of the wiring layer. As described in this modification, it is possible to suppress the variation of the shapes of the heating elements if a separate wiring layer is provided in addition to the wiring layer directly connected to the heating elements.

<Modification 2>

Figs. 17D and 17E are diagrams describing another modification. In Figs. 17A to 17C, the embodiment where the electrode pads 1201 and 1202 are formed on the same surface of the substrate on which the heating elements 10 are formed is described. As described above, the surface on which the heating elements 10 are formed includes a region (liquid chamber) in contact with the liquid to generate the UFBs. The liquid chamber is covered with the walls and the lid. Meanwhile, the electrode pads 1201 and 1202 are arranged outside the liquid chamber. If the heating elements 10 and the electrode pads 1201 and 1202 are electrically separated from each other like this case, the routing of the wiring is long. Figs. 17D and 17E illustrate the embodiment where the electrode pads 1201 and 1202 are not provided on the same surface on which the heating elements are provided, and through-holes penetrating to the other surface of the element substrate are formed to provide the electrode pads and a wiring layer on the back surface of the element substrate. Fig. 17E is a cross-sectional view taken along the XVIIE-XVIIE line in Fig. 17D.

As illustrated in Figs. 17D and 17E, a wiring layer 1741 is formed on a large portion of the back surface of the element substrate. The back surface of the element substrate is the opposite surface of the surface on which the heating elements are formed. Since there is no effect of heat stress from the heating elements 10 on the back surface of the element substrate, the large portion of the back surface of the element substrate is used as the wiring layer 1741. Through-holes 1742 connect the wiring layer on the surface on which the heating elements are formed and the wiring layer 1741 on the back surface. The wiring layer 1741 is a layer of the common wiring, and forming the wiring layer 1741 on the large portion of the back surface makes it possible to reduce the wiring resistances in the common wiring. In this embodiment, an electrode pad 1751 is formed on the large portion (same as the area of the wiring layer 1741 in the example in Fig. 17E) on the back surface. The configuration in Figs. 17D and 17E makes it possible to arrange the heating elements 10 densely and also reduce the wiring resistances in the common wiring. Consequently, it is possible to stably generate the UFBs even in the case of arranging the heating elements 10 densely. Additionally, since the electrode pad is formed on the back surface, it is possible to provide the liquid chamber in the large portion of the surface on which the heating elements 10 are formed. Consequently, it is possible to generate the UFBs in a short time by arranging the heating elements 10 densely.

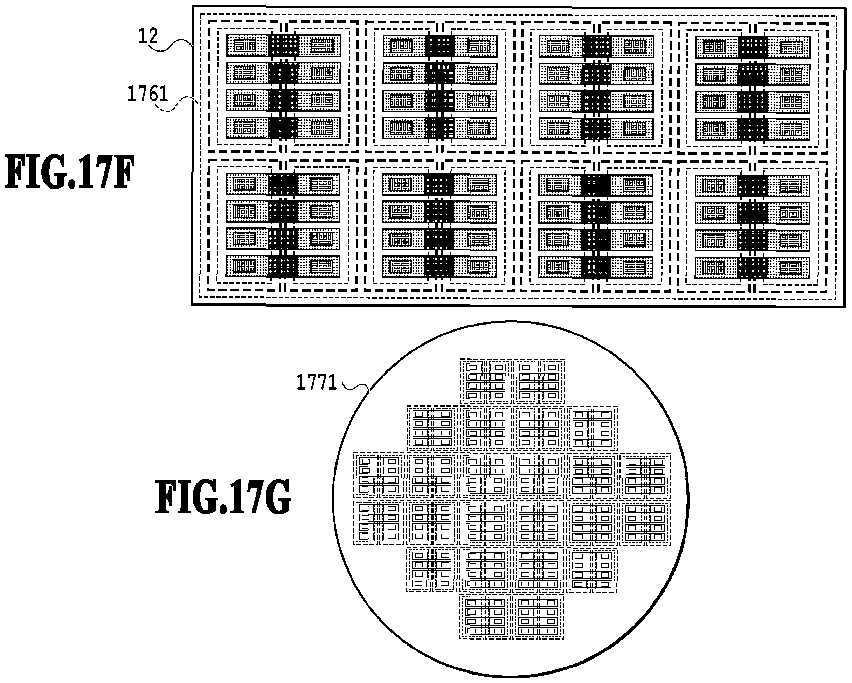

Fig. 17F is a diagram illustrating an example of the element substrate 12 on which the multiple elements illustrated in Fig. 17D are arranged. Since the electrode pads are not formed on the same surface on which the heating elements are formed in the element substrate 12 in Fig. 17F, walls 1761 are formed to reach an outer peripheral portion of the element substrate 12. Although Fig. 17F is a simple illustration for the sake of description, it is still possible to generate the UFBs at high speed by increasing the number of the heating elements and the number of the elements.

Fig. 17G is a diagram illustrating an example where the elements illustrated in Fig. 17D are arranged on the entirety of a wafer 1771. Although the element substrate 12 is cut into a rectangular shape in the above-described embodiments, there is no limitation on the shape of the element substrate 12 for generating the UFBs. Thus, as illustrated in Fig. 17G, it is possible to apply the whole wafer 1771 to the T-UFB generating unit 300 without cutting out the substrate on which the heating elements and the wirings are formed.

As described with reference to Figs. 17D to 17G, in the case of performing the back surface wiring of the element substrate 12 to arrange the electrode pads on the back surface, the electrode pads can be separated easily from the liquid for generating the UFBs. In the case of providing the electrode pads on the back surface of the element substrate 12, a driver, a switch, and the like outputting the supply voltage pulse are implemented by external devices. For example, the stable generation of the UFBs can be made by driving the driver and the like connected with the wafer 1771 in Fig. 17G.

<Embodiment 4>

In Embodiment 2, the embodiment where no common wirings are used but the independent individual wirings are is described. In this embodiment, an embodiment where the individual wirings are used like Embodiment 2 and the multiple heating elements 10 are connected to the individual wirings is described.

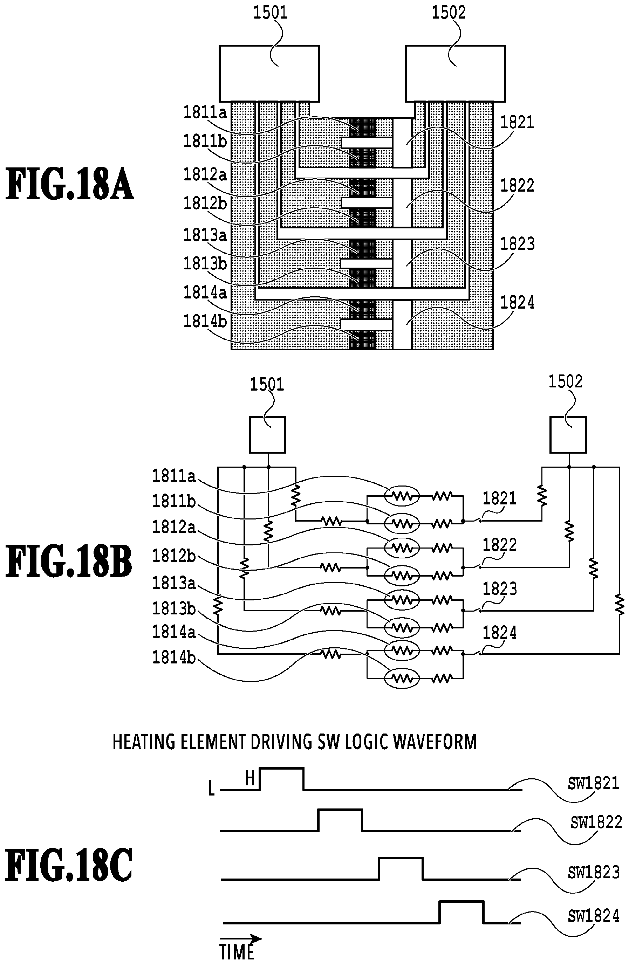

Figs. 18A to 18C are diagrams describing an embodiment of stably generating the UFBs. Fig. 18A is a diagram illustrating a planar layout. As described above, it is required to drive more heating elements simultaneously to generate the UFBs in a short time. Fig. 18A illustrates an example where the heating elements more than that in Fig. 15F are provided. As illustrated in Fig. 18A, SWs 1821 to 1824 are provided in independent wiring regions, respectively. Additionally, multiple heating elements are provided on each of independent wirings, respectively. This embodiment is an embodiment where the multiple heating elements provided on the same wiring region are driven simultaneously while the driving timings are changed in the time division manner by the SWs 1821 to 1824.

Fig. 18B is an electric circuit of Fig. 18A, and Fig. 18C illustrates the driving timings of the SWs 1821 to 1824. In heating elements 1811 to 1814, branch numbers of the heating elements driven simultaneously are indicated by "a" and "b". For example, in the case where the SW 1821 is set to "H", heating elements 1811a and 1811b are driven.

Such a configuration makes it possible to input substantially the same energies to the heating elements driven simultaneously even if there is a common wiring portion for the multiple heating elements. Consequently, it is possible to suppress the variation of energies inputted to the heating elements driven simultaneously.

<Embodiment 5>

In Embodiment 1, the embodiment where the variation of energies inputted to the heating elements is suppressed by the driving controlled in the time division manner using the SWs provided to the individual wirings connected to the heating elements is described. If the common wiring regions are shrunk to achieve higher density, there may occur the variation of energies inputted to the heating elements even in the case of performing the driving controlled in the time division manner using the SWs. This is because the heating element positioned farther from the electrode pads 1201 and 1202 and the heating element positioned closer to the electrode pads 1201 and 1202 have the different wiring resistances in the common wiring regions, as described in Embodiment 1.

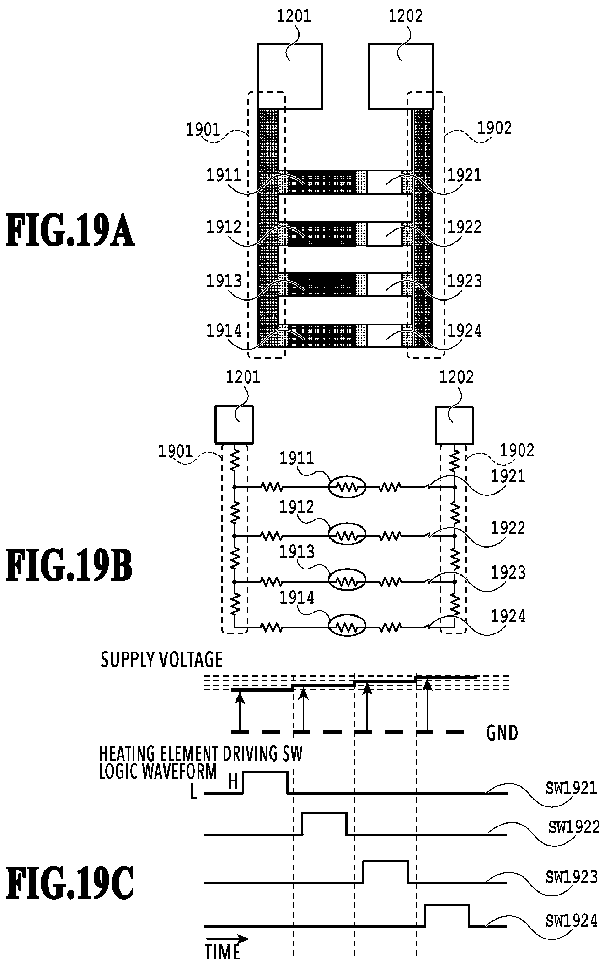

Figs. 19A to 19C are diagrams describing an embodiment of stably generating the UFBs. This embodiment is an embodiment of performing additional control in addition to the shifting of the driving timings of the heating elements in the time division manner. Fig. 19A is a diagram illustrating a layout. Similar to the embodiment described with reference to Fig. 14A, this embodiment is an embodiment where SWs 1921 to 1924 are arranged in the individual wiring regions. This embodiment is an embodiment where the supply voltages of the heating elements are changed in accordance with the driving of the SWs 1921 to 1924. Fig. 19B illustrates an electric circuit of Fig. 19A, and Fig. 19C is a diagram illustrating driving timings of the SWs and values of the supply voltages according to the driving timings.

In this embodiment, the heating elements are driven in the time division manner by using the SWs 1921 to 1924, and the voltages are changed in the time division manner so as to suppress the variation of energies inputted to the heating elements in each timing in the time division manner.

As illustrated in Fig. 19C, the supply voltage in the timing in which the SW 1921 drives a heating element 1911 having the smallest wiring resistance is lower than the supply voltages in the timings for driving other heating elements 1912 to 1914. Additionally, as illustrated in Fig. 19C, the configuration is made such that the supply voltages in the timings for driving other heating elements 1912 to 1914 are increased as the wiring resistances are increased. Although the embodiment where the supply voltages are changed in the time division manner is illustrated in Fig. 19C, instead of the supply voltages, the pulse widths of control signals for driving the SWs may be changed to suppress the variation of energies. Specifically, the time length of driving each heating element may be changed by changing the pulse width of the control signal for driving the corresponding SW. Additionally, the control in the time division manner of the supply voltages and the pulse widths control may be combined with each other.

This embodiment makes it possible to suppress the variation of energies inputted to the heating elements even in the case where the wiring widths of the common wiring regions are the same, for example.

<Embodiment 6>

In the above embodiments, the descriptions are given with the assumption that the heating elements 10 mounted in the element substrate 12 are produced in the step of photolithography of a semiconductor and have the same shape and the same resistance. Additionally, in the configuration described with reference to Fig. 12B in Embodiment 1, for example, it is described that the variation of energies inputted to the heating elements occurs because the current flowing through the heating element 1064 is smaller than that flowing through the heating element 1061. In this embodiment, the heating elements 10 are made in different shapes depending on the positional relationship of arrangement of the heating elements.

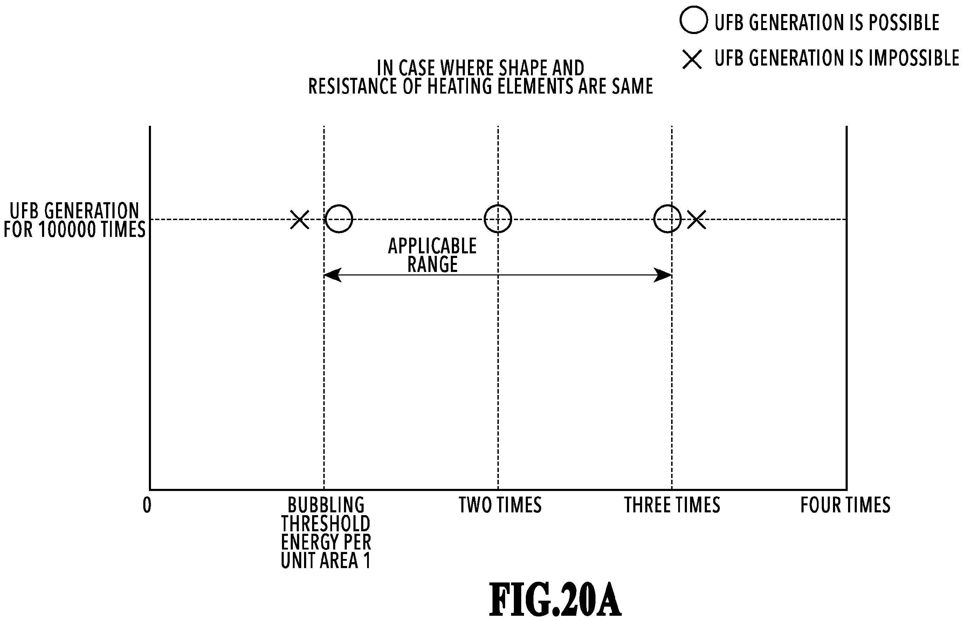

Figs. 20A to 20C are diagrams describing an embodiment for stably generating the UFBs. Fig. 20A is a diagram indicating whether it is possible to generate the UFBs in the case where the heating elements are made in different shapes to have the resistance values different from each other, based on the heating element capable of generating the film boiling 100,000 times as illustrated in Fig. 16A. In the case where the bubbling threshold energy per predetermined unit area of the heating element was set to "1" and the shapes and the resistance values of the heating elements are changed, it was possible to generate the film boiling 100,000 times with the resistance values achieving the inputted energies of 1.1 times the bubbling threshold energy to 3 times the bubbling threshold energy. That is, it is possible to stably generate the UFBs even in the case of changing the shapes and the resistance values of the heating elements, as long as the range of the changing falls within the above-described range. In this embodiment, stable UFBs are generated by changing the shapes of the heating elements depending on the inputted energies.

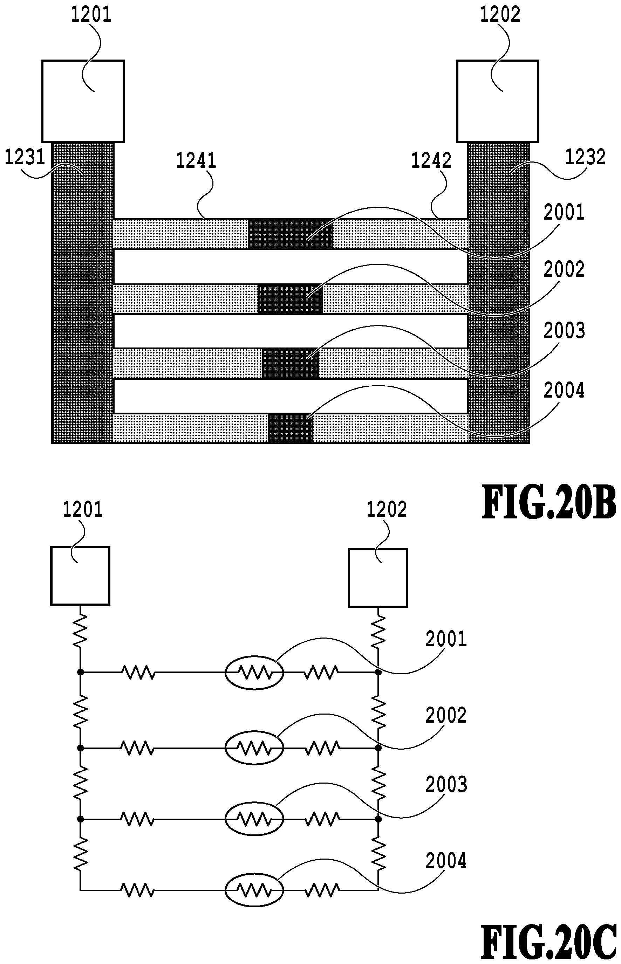

Fig. 20B is a diagram illustrating an example of a layout of this embodiment. Fig. 20C is a diagram illustrating an electric circuit of Fig. 20B. Since the energy flowing through a heating element 2001 positioned closer to the electrode pads 1201 and 1202 has a small wiring resistance loss, the energy is greater than the energy flowing through the heating element 2004 positioned farther from the electrode pads 1201 and 1202. For this reason, the shapes of the heating elements are determined so as to make the energies per unit area equal. Specifically, the length of a resistance pattern of the heating element 2001 (in a direction in which the resistance is increased as the length becomes longer) is made longer than the length of a resistance pattern of the heating element 2004. That is, the length in a current flow direction of the heating element 2001 is made longer than the length in a current flow direction of the heating element 2004. More specifically, the closer the heating element is to the electrode pads 1201 and 1202 from the heating element 2004 far from the electrode pads 1201 and 1202, the longer the length of the resistance pattern of the heating element is.

In the case where the heating elements 10 are made in different shapes, the film boiling bubbles 13 may be formed in different shapes. That is, it is more useful in terms of generating uniform film boiling bubbles 13 with the heating elements 10 having the same shape. However, as described above, generating the UFBs requires at least the film boiling bubbles 13 generated among the heating elements, and forming uniform film boiling bubbles 13 is not necessarily required. This embodiment focuses on suppressing the variation of energies inputted to the heating elements 10, and the UFBs are stably generated by changing the shapes of the heating elements 10 depending on the inputted energies.

<Embodiment 7>

In this embodiment, an embodiment where the resistance values of the heating elements are monitored, and the supplied voltages or the applied pulse widths of the heating elements are adjusted according to the resistance values of the heating elements being monitored is described.

In Embodiments 1 to 5, the descriptions are given with the assumption that the heating elements have the same shape and the same resistance, and in Embodiment 6, the embodiment where the shapes of the heating elements are changed is described. In order to generate the UFBs at high speed in a shorter time, it is required to enlarge the element substrate or arrange the heating elements on the entire wafer as illustrated in Fig. 17G. In this case, the in-plane distribution of the film thickness or the in-plane variation of the heating element patterning, for example, may cause the variation of the initially designed sizes and resistance values of the heating elements. This may change the energies inputted to the heating elements and make it difficult to stably generate the UFBs.

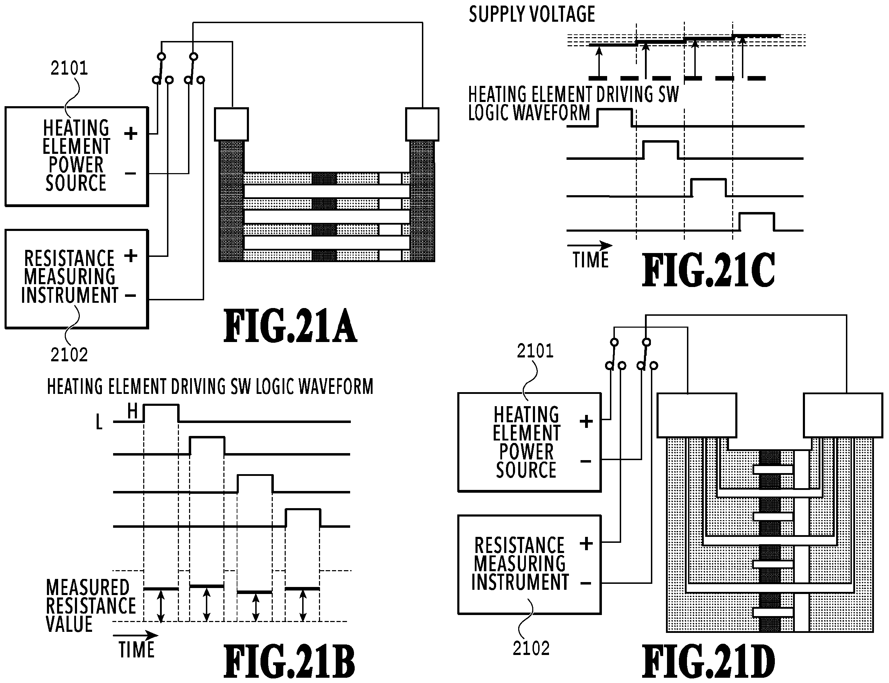

Figs. 21A to 21D are diagrams describing an embodiment for stably generating the UFBs. Fig. 21A is a diagram illustrating an example of a layout. This embodiment is an embodiment where a power source 2101 of the heating element and also a resistance measurement instrument 2102 are provided. The resistance measurement instrument 2102 monitors the resistance value of the heating element. Then, the energy to be inputted to the heating element is adjusted in accordance with the monitored resistance value. This makes it possible to suppress the variation of energies during generation of the UFBs using a considerably large heating element substrate, such as the whole wafer. Fig. 21B is an example of adjusting the applied pulse width in accordance with the monitored resistance value. Fig. 21C is an example of adjusting the supply voltage of the heating element in accordance with the monitored resistance value. As illustrated in Figs. 21B and 21C, adjusting of the inputted energies may be performed in the time division manner or may be performed by a block unit with the heating elements divided into blocks.

<Modification>

Fig. 21D is a diagram illustrating a modification. The configuration in Fig. 21A illustrates an embodiment where the control in the time division manner is performed, and one heating element is driven in each of the timings in the time division manner. Fig. 21D is an example of driving multiple heating elements in each of the timings in the time division manner during the control in the time division manner. As illustrated in Fig. 21D, adjusting of the voltage or the pulse width may be controlled in the time division manner with the number of the simultaneously driven heating elements set the same.

<Embodiment 8>

In the above embodiments, the embodiment where the blocks corresponding to the SWs each include the same number of the multiple heating elements, which are driven simultaneously by the corresponding SW, is described. In this embodiment, the embodiment where the number of the heating elements driven simultaneously by the corresponding SW is changed depending on the blocks is described.

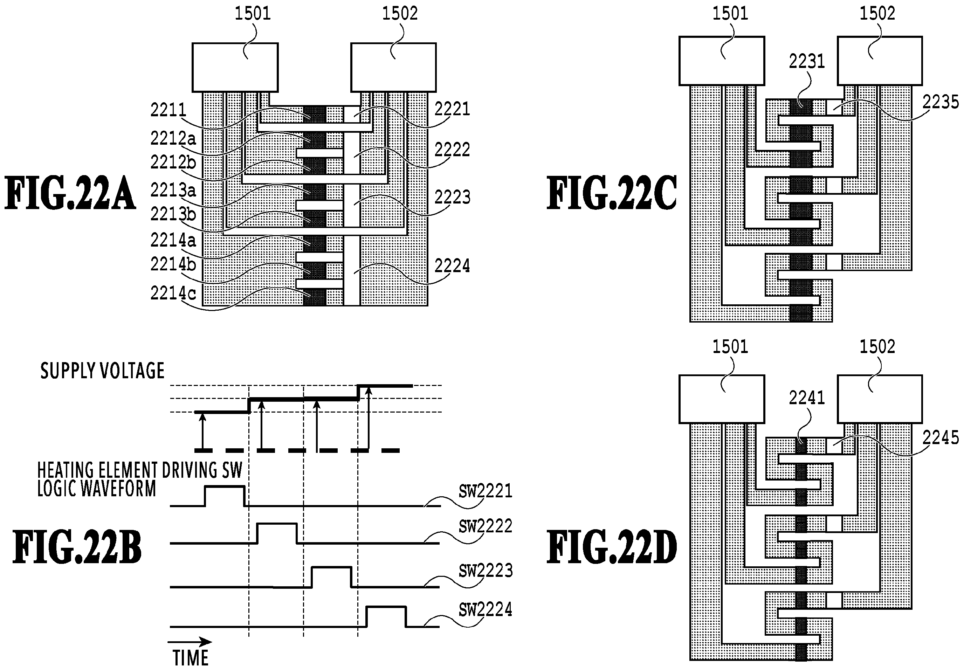

Figs. 22A to 22D are diagrams describing an embodiment for stably generating the UFBs. Fig. 22A is a diagram describing a layout of this embodiment. One heating element 2211 is arranged in a block corresponding to a SW 2221. Two heating elements 2212a and 2212b are arranged in a block corresponding to a SW 2222. Two heating elements 2213a and 2213b are arranged in a block corresponding to a SW 2223. Three heating elements 2214a, 2214b, and 2214c are arranged in a block corresponding to a SW 2224. Fig. 22B illustrates an example of adjusting the supply voltage in accordance with the number of the heating elements driven simultaneously. Even in such an embodiment, it is possible to suppress the variation of energies inputted to the heating elements.

<Embodiment 9>

In the above embodiments, the embodiment where the multiple heating elements connected from the electrode pads are electrically connected in parallel is described. In this embodiment, an embodiment where the multiple heating elements connected from the electrode pads are electrically connected in series on the same wiring is described.
Fig. 22C is a diagram describing a layout of this embodiment. As illustrated in Fig. 22C, it is possible to make the currents constant by connecting the heating elements 2231 in series. Additionally, it is possible to generate the UFBs at high speed by driving the multiple heating elements.

<Modification>

Fig. 22D is a diagram illustrating a modification. Fig. 22D illustrates an example where the width of the resistance pattern of the heating element is made longer than the length of the resistance pattern in the case of connecting the heating elements in series. In the series connection, the supply voltage for driving the heating element is high because of the series connection. If a high voltage is not desirable as the driving power source of the heating element, the configuration illustrated in Fig. 22D can prevent the supply voltage of the heating element from being high while maintaining the area of the heating element. The embodiment like this where the multiple heating elements having wide widths are connected in series may be employed.

<Embodiment 10>

In the above embodiments, the embodiment where the variation of energies inputted to the heating elements is suppressed by adjusting the layout or adjusting the driving timing is described. In this embodiment, an embodiment provided with a mechanism that keeps a voltage in two ends or one end of the heating element constant is described.

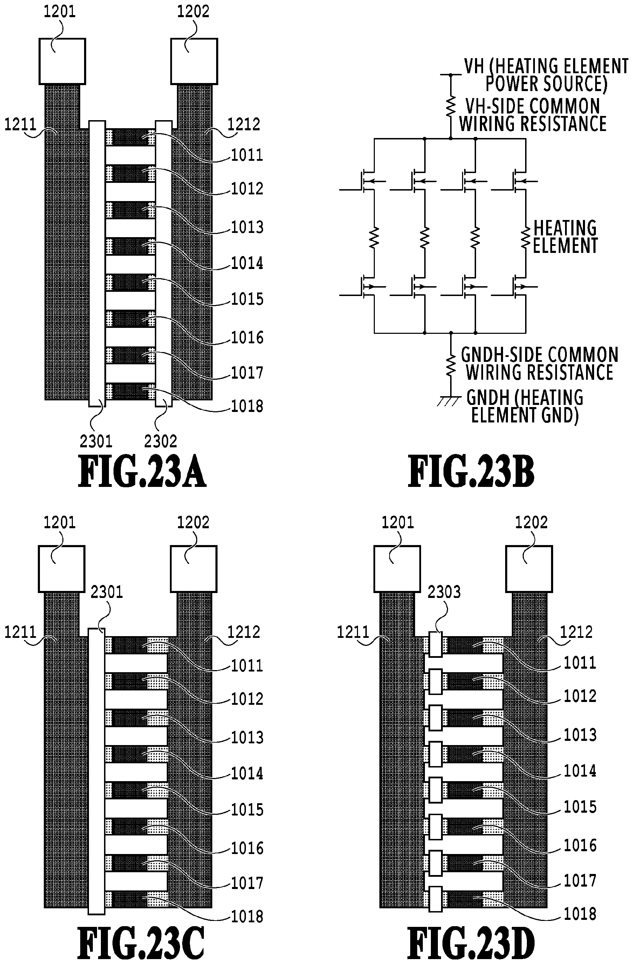

Figs. 23A to 23D are diagrams describing an embodiment for stably generating the UFBs. Fig. 23A is an embodiment where circuits 2301 and 2302 for making voltage constant are arranged in two ends of the heating elements 1011 to 1018 to maintain the energies inputted to the heating elements constant. It is possible to suppress the variation of energies inputted to the heating elements by forcibly maintaining the voltages constant in the connection portions of the heating elements 1011 to 1018 using the circuits 2301 and 2302 for making voltage constant. Fig. 23B is a diagram illustrating a source follower as an example of the circuit for making voltage constant. Using the circuit for making voltage constant makes it possible to absorb the difference between the wiring resistance losses, and thus it is possible to suppress the variation of energies inputted to the heating elements.

Figs. 23C and 23D are diagrams illustrating layouts in which a circuit 2301 and circuits 2303 for making the voltages on one side constant are arranged respectively. Although the circuit for making voltage constant is arranged on only one side, it is still possible to obtain the effect of making the voltage applied to the heating element constant. Additionally, the circuit for making voltage constant may be arranged so as to precede branches to the individual wiring regions as illustrated in Fig. 23C, and the circuit for making voltage constant may be arranged so as to follow the branches to the individual wiring regions as illustrated in Fig. 23D. Although the embodiment where the circuit for making voltage constant is arranged is described herein, there may be applied a configuration in which a circuit for making current constant that makes the currents flowing through the heating elements constant are arranged in two ends or one end of the heating element.

<Modification>

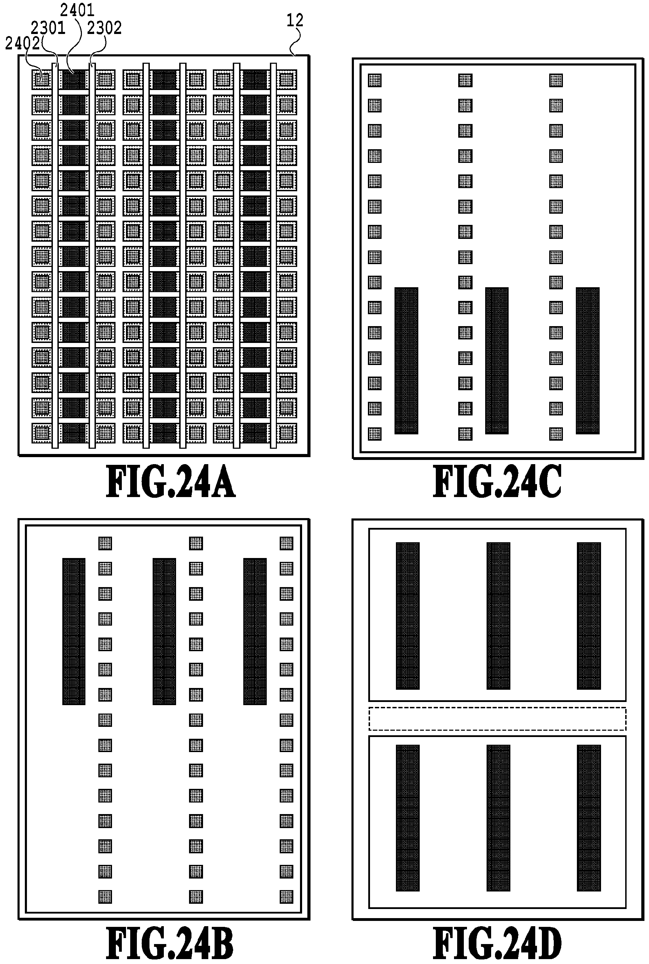

Figs. 24A to 24D are diagrams illustrating modifications for stably generating the UFBs. Fig. 24A illustrates an upper surface layer on which heating elements 2401 are arranged, Fig. 24B illustrates a second layer below the upper surface layer, Fig. 24C illustrates a third layer below the second layer, and Fig. 24D illustrates a back surface layer. The circuits 2301 and 2302 for making voltage constant are arranged in connection portions in two ends of the heating elements 2401. With the circuits 2301 and 2302 for making voltage constant provided, it is possible to suppress the variation of energies inputted to a number of heating elements and arrange the heating elements densely. Also, the embodiment allows the power to be supplied from the back surface through through-holes 2402.

<Other Embodiments>

In the above embodiments, the descriptions are given with the assumption that the UFBs are generated under a condition of a constant temperature and a constant environment pressure. That is, variable temperatures and environment pressures are not taken into consideration. Since the UFB generating apparatus generates the UFBs by driving the heating elements, the temperature of the UFB generating apparatus 1 (particularly, the UFB generating unit provided with the heating elements) is varied. Because the film boiling is generated at around 300°C under atmospheric pressure, the energy to be applied may be increased and decreased in accordance with the temperature of the UFB generating unit, and this makes it possible to stably generate the UFBs.

In order to generate the UFBs using a desired gas, it is desirable to generate the film boiling after dissolving the gas as much as possible into the UFB generating liquid. In this case, with the UFB generated while the whole UFB generating apparatus 1 is set under a high pressure (for example, triple to quadruple the average air pressure), it is possible to stably generate the UFBs from the desired gas more efficiently. In this case, since the temperature at which the film boiling is generated is also increased in the high pressure, the applied energy is increased in accordance with the film boiling threshold, and thus it is possible to suppress the variation of energies like the above-described embodiments.

According to the present disclosure, it is possible to generate a UFB-containing liquid efficiently.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

An ultrafine bubble generating apparatus (300) that generates ultrafine bubbles (11) by causing a heating element (10) to generate film boiling (13) in a liquid (W) includes: an element substrate (12) including a heating part (1250) provided with multiple heating elements, in which the element substrate is configured to suppress variation of energies inputted to the heating elements in the heating part.

**Claims**

1. An ultrafine bubble generating apparatus (300) that generates ultrafine bubbles (11) by causing a heating element (10) to generate film boiling (13) in a liquid (W), comprising:

   an element substrate (12) including a heating part (1250) provided with a plurality of the heating elements, wherein
   the element substrate is configured to suppress variation of energies inputted to the heating elements in the heating part.

**2.** The ultrafine bubble generating apparatus according to claim 1, wherein
the heating part includes an aggregate of the heating elements to which energies from an electrode pad are inputted.

**3.** The ultrafine bubble generating apparatus according to claim 2, wherein
at least two or more of the heating elements are connected to the electrode pad through the same common wiring in the heating part, and
the plurality of the heating elements are driven in a time division manner.

**4.** The ultrafine bubble generating apparatus according to claim 3, wherein
the element substrate includes a plurality of the heating parts, and
in each of the plurality of the heating parts, the plurality of the heating elements are driven in the time division manner.

**5.** The ultrafine bubble generating apparatus according to claim 3, wherein
shapes of the heating elements in the heating part are different depending on a positional relationship of the heating elements connected to each other through the common wiring.

**6.** The ultrafine bubble generating apparatus according to any one of claims 3 to 5, wherein
a voltage applied to each of the heating elements in the time division manner or a time length in which the heating elements are driven is changed depending on a difference between resistances in the common wiring.

**7.** The ultrafine bubble generating apparatus according to claim 1 or 2, wherein
in the heating part, the heating elements are each connected to an individual wiring.

**8.** The ultrafine bubble generating apparatus according to claim 7, wherein
the individual wirings are laid out such that a resistance value of each individual wiring falls within a predetermined range.

**9.** The ultrafine bubble generating apparatus according to claim 3, wherein
a width or a film thickness of the common wiring is set so that a value of a resistance in the common wiring is at a predetermined ratio or less to the sum of a resistance of the heating element and a resistance of a wiring individually connected to the heating element.

**10.** The ultrafine bubble generating apparatus according to claim 9, wherein
the width or the film thickness of the common wiring is set so that, in a case where an energy for generating the film boiling by the heating element is set to a first value, energies respectively inputted to the plurality of the heating elements connected to the common wiring are set to 1.1 times or more and 3 times or less the first value.

**11.** The ultrafine bubble generating apparatus according to claim 9 or 10, wherein
the common wiring is formed on a layer different from a layer on which the heating element is formed in the element substrate.

**12.** The ultrafine bubble generating apparatus according to claim 9, wherein
the common wiring is formed on a back surface of the element substrate opposite to a surface on which the heating element is formed.

**13.** The ultrafine bubble generating apparatus according to claim 12, wherein
the electrode pad is formed on the back surface.

**14.** The ultrafine bubble generating apparatus according to any one of claims 9 to 11, further comprising:
a generating unit in which a plurality of the element substrates are formed on a wafer.

**15.** The ultrafine bubble generating apparatus according to claim 7, wherein
a plurality of groups, which include a group provided with at least two or more heating elements that are each connected to the individual wiring and are driven simultaneously, are driven in different timings in a time division manner.

**16.** The ultrafine bubble generating apparatus according to claim 15, wherein
in the heating part, each of the groups includes the same number of the heating elements driven simultaneously.

**17.** The ultrafine bubble generating apparatus according to claim 15, wherein
the groups each provided with at least two or more heating elements driven simultaneously in the heating part are driven in timings in different time-divisions, and a voltage applied to each of the heating elements or a time length in which the heating elements are driven is changed depending on the number of the heating elements driven simultaneously in each timing.

**18.** The ultrafine bubble generating apparatus according to claim 6 or 17, further comprising:

a monitoring unit that monitors a resistance of the heating elements in the heating part, wherein
a voltage applied to each of the heating elements in the time division manner or a time length in which the heating elements are driven is changed depending on a result of the monitoring by the monitoring unit.

**19.** The ultrafine bubble generating apparatus according to claim 15, wherein
in the heating part, a plurality of the heating elements driven simultaneously on the same wiring are connected in series.

**20.** The ultrafine bubble generating apparatus according to claim 19, wherein
in each of the heating elements connected in series, a length of a resistance pattern in a current flow direction is smaller than a width of the resistance pattern.

**21.** The ultrafine bubble generating apparatus according to claim 1 or 2, further comprising:
a unit for making energy constant that makes an energy applied to each of the plurality of the heating elements or each of a predetermined number of the heating elements constant, in the heating part.

**22.** The ultrafine bubble generating apparatus according to claim 21, wherein
the unit for making energy constant maintains a voltage or a current constant in two ends or one end of each of the heating elements.

FIG.1

EP 3 703 467 A1

**FIG.2**

EP 3 703 467 A1

**FIG.3A**

**FIG.3B**

**FIG.4**

**FIG.5A**

**FIG.5B**

FILM BOILING
BUBBLE INTERNAL PRESSURE

FILM BOILING
BUBBLE VOLUME

ATMOSPHERIC
PRESSURE

TIMING 1  TIMING 2          TIMING 3          TIME

VOLTAGE

TIME

## FIG.6A

11

13

10

12

TIMING 1          TIMING 2          TIMING 3

## FIG.6B

FIG.7A

FIG.7B

FIG.7C

FIG.7D

EP 3 703 467 A1

**FIG.8A**

300

11B

15

302

3

301

W

303

10    13    12

**FIG.8B**

300

11B    15

302

3

301

W

303

10    13    12

**FIG.8C**

300

15

302

3

301

W

303

10    13    11B    12

**FIG.9A**

3
301
W
10    13    12

**FIG.9B**

16
3
301
10    13   11C    12

**FIG.9C**

16
3
301
10    13   11C    12

**FIG.10A**

**FIG.10B**

**FIG.11A**

**FIG.11B**

**FIG.11C**

EP 3 703 467 A1

1250

1201          1202

1211          1212

1221a  1011  1221b
1222a  1012  1222b
1223a  1013  1223b
1224a  1014  1224b
1225a  1015  1225b
1226a  1016  1226b
1227a  1017  1227b
1228a  1018  1228b

**FIG.12A**

1250

1201          1202

1231          1232

1241a  1061  1241b
1242a  1062  1242b
1243a  1063  1243b
1244a  1064  1244b

**FIG.12B**

**FIG.13A**

**FIG.13B**

1201          1202

1231          1232

1241a    1061   1241b    1401

1242a    1062   1242b    1402

1243a    1063   1243b    1403

1244a    1064   1244b    1404

**FIG.14A**

HEATING ELEMENT DRIVING SW LOGIC WAVEFORM

L   H               SW1401

SW1402

SW1403

SW1404

TIME   **FIG.14B**

12

1201    1202                  1421

**FIG.14C**

1511    10    1512

1501    1502

**FIG.15A**

1501    1502

**FIG.15B**

**FIG.15C**

**FIG.15D**

**FIG.15E**

**FIG.15F**

FIG.16A

EP 3 703 467 A1

**FIG.16B**

**FIG.16C**

**FIG.16D**

**FIG.16E**

**FIG.17A**

**FIG.17D**

**FIG.17B**

**FIG.17E**

**FIG.17C**

**FIG.17F**

12

1761

**FIG.17G**

1771

EP 3 703 467 A1

FIG.18A

FIG.18B

HEATING ELEMENT DRIVING SW LOGIC WAVEFORM

FIG.18C

**FIG.19A**

1201   1202

1901   1902

1911   1921
1912   1922
1913   1923
1914   1924

**FIG.19B**

1201   1202

1901   1902

1911   1921
1912   1922
1913   1923
1914   1924

**FIG.19C**

SUPPLY VOLTAGE

GND

HEATING ELEMENT DRIVING SW
LOGIC WAVEFORM

H
L

SW1921
SW1922
SW1923
SW1924

TIME

FIG.20A

1201  1202

1231  1241  1242  1232

2001

2002

2003

2004

**FIG.20B**

1201  1202

2001

2002

2003

2004

**FIG.20C**

SUPPLY VOLTAGE

HEATING ELEMENT DRIVING SW
LOGIC WAVEFORM

TIME

**FIG.21C**

2101

HEATING
ELEMENT
POWER
SOURCE

RESISTANCE
MEASURING
INSTRUMENT

**FIG.21A**

2102

HEATING ELEMENT DRIVING SW LOGIC WAVEFORM

L    H

MEASURED
RESISTANCE
VALUE

TIME

**FIG.21B**

2101

HEATING
ELEMENT
POWER
SOURCE

RESISTANCE
MEASURING
INSTRUMENT

2102

**FIG.21D**

FIG.22A

FIG.22B

FIG.22C

FIG.22D

EP 3 703 467 A1

1201    1202

1211    1212
1011
1012
1013
1014
1015
1016
1017
1018

2301    2302

**FIG.23A**

VH (HEATING ELEMENT POWER SOURCE)
VH-SIDE COMMON WIRING RESISTANCE

HEATING ELEMENT

GNDH-SIDE COMMON WIRING RESISTANCE

GNDH (HEATING ELEMENT GND)

**FIG.23B**

1201    1202

2301

1211    1212
1011
1012
1013
1014
1015
1016
1017
1018

**FIG.23C**

1201    1202

2303

1211    1212
1011
1012
1013
1014
1015
1016
1017
1018

**FIG.23D**

**FIG.24A**

**FIG.24C**

**FIG.24B**

**FIG.24D**

Europäisches
Patentamt

European
Patent Office

Office européen
des brevets

# EUROPEAN SEARCH REPORT

**Application Number**

EP 20 15 9704

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,P | WO 2019/044631 A1 (CANON KK [JP]) 7 March 2019 (2019-03-07) * paragraph [0018] - paragraph [0030]; figures 3E,4B,7B * | 1-22 | INV. H05B1/02 H05B3/26 H05B3/82 |
| X,P | WO 2019/044913 A1 (CANON KK [JP]) 7 March 2019 (2019-03-07) * paragraph [0012] - paragraph [0022]; figures 1,3 * | 1-22 | |
| X | EP 0 920 997 A2 (CANON KK [JP]) 9 June 1999 (1999-06-09) * paragraph [0067] - paragraph [0068]; figures 7,8 * | 1-22 | |
| X | EP 0 956 953 A2 (CANON KK [JP]) 17 November 1999 (1999-11-17) * paragraph [0031] - paragraph [0035]; figures 1,2 * | 1-22 | |

TECHNICAL FIELDS
SEARCHED (IPC)

H05B
B01F

The present search report has been drawn up for all claims

| Place of search | Date of completion of the search | Examiner |
|---|---|---|
| Munich | 13 July 2020 | Gea Haupt, Martin |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 20 15 9704

This annex lists the patent family members relating to the patent documents cited in the above-mentioned European search report.
The members are as contained in the European Patent Office EDP file on
The European Patent Office is in no way liable for these particulars which are merely given for the purpose of information.

13-07-2020

| Patent document cited in search report | | Publication date | Patent family member(s) | | Publication date |
|---|---|---|---|---|---|
| WO 2019044631 | A1 | 07-03-2019 | CN | 111148578 A | 12-05-2020 |
| | | | JP | 2019042664 A | 22-03-2019 |
| | | | US | 2020197963 A1 | 25-06-2020 |
| | | | WO | 2019044631 A1 | 07-03-2019 |
| WO 2019044913 | A1 | 07-03-2019 | NONE | | |
| EP 0920997 | A2 | 09-06-1999 | AU | 760829 B2 | 22-05-2003 |
| | | | CA | 2255405 A1 | 05-06-1999 |
| | | | CN | 1223932 A | 28-07-1999 |
| | | | DE | 69836617 T2 | 27-09-2007 |
| | | | EP | 0920997 A2 | 09-06-1999 |
| | | | JP | H11227210 A | 24-08-1999 |
| | | | KR | 19990062806 A | 26-07-1999 |
| | | | US | 2002012026 A1 | 31-01-2002 |
| EP 0956953 | A2 | 17-11-1999 | DE | 69934452 T2 | 27-09-2007 |
| | | | EP | 0956953 A2 | 17-11-1999 |
| | | | JP | 3728137 B2 | 21-12-2005 |
| | | | JP | 2000000973 A | 07-01-2000 |
| | | | US | 6436301 B1 | 20-08-2002 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6118544 B

- JP 4456176 B